# EUROPEAN PATENT APPLICATION

(11) **EP 4 621 487 A1**
(43) Date of publication of application: **24.09.2025**
(21) Application number: 23891601.9
(22) Date of filing: 15.11.2023
(51) Int. Cl.: G03F 7/11, G03F 7/20, G03F 7/40

(54) **RESIST UNDERLAYER FILM-FORMING COMPOSITION CONTAINING CURCUMIN DERIVATIVE**

(30) Priority: 16.11.2022 JP 2022183068
(71) Applicant: Nissan Chemical Corporation, Tokyo 103-6119 (JP)
(72) Inventor: KUBODERA Shun, Toyama-shi, Toyama 939-2792 (JP)
(74) Representative: Hoffmann Eitle
(86) International application number: PCT/JP2023/041053
(87) International publication number: WO 2024/106454

(57) **Abstract**

Provided is a resist underlayer film that exhibits excellent removability (solubility) in a wet etching chemical liquid while mainly exhibiting excellent resistance to a resist solvent, which is an organic solvent, or a resist developer, which is an alkaline aqueous solution.

A resist underlayer film-forming composition contains at least any one of a compound having a partial structure represented by Formula (1) or a polymer having a partial structure represented by Formula (1), and a solvent.

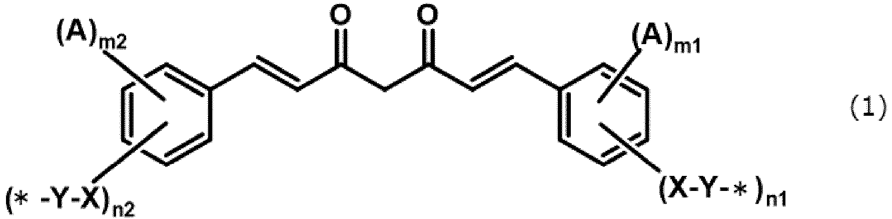

(In formula (1), each -X- independently represents -O-, -S-, -NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.)

## Description

### Technical Field

The present invention relates to a resist underlayer film-forming composition containing a curcumin derivative, a resist underlayer film obtained using the resist underlayer film-forming composition, a method for manufacturing a patterned substrate and a method for manufacturing a semiconductor device using the resist underlayer film-forming composition, and a curcumin derivative compound.

### Background Art

In manufacturing a semiconductor, a lithography process for forming a resist pattern having a desired shape by providing a resist underlayer film between a substrate and a resist film formed thereon is widely known. After the resist pattern is formed, the resist underlayer film is removed and the substrate is processed, and dry etching is mainly used as the process. Patent Literature 1 discloses an anti-reflective coating composition for obtaining a desired resist pattern by applying a resist onto a resist underlayer film and performing exposure and development using radiation (for example, ArF excimer laser light, KrF excimer laser light, or an i-ray). On the other hand, in the three-dimensional mounting field of semiconductor manufacturing processes, a fan-out wafer level package (FOWLP) process has started to be applied for the purpose of high-speed responsiveness and power saving by shortening a wiring length between semiconductor chips, and a lithography process using an i-ray is used in a redistribution layer (RDL) process of creating a wiring between semiconductor chips, but simplification of the process is strongly desired in order to reduce the process cost. In general, dry etching is also used in a process of removing an unnecessary resist pattern or a base resist underlayer film after substrate processing, but wet etching using a chemical liquid may be used particularly in the RDL process for the purpose of simplifying the process or reducing damage to the processed substrate.

### Citation List

### Patent Literature

Patent Literature 1: WO 2009/008446 A

### Summary of Invention

### Technical Problem

As described above, in the FOWLP process which is one of the three-dimensional mounting techniques of the semiconductor manufacturing process, there is a redistribution layer (RDL) process using i-ray lithography. In particular, in a so-called post-process such as the RDL process, in order to reduce the process cost, the resist underlayer film is strongly required to have wet etching removability in a chemical liquid. In a case where the resist underlayer film is removed by wet etching with a chemical liquid, the resist underlayer film is required to have sufficient solubility in a wet etching chemical liquid and to be easily removed from the substrate.

On the other hand, as a wet etching chemical liquid for removing the resist and the resist underlayer film, an organic solvent is used in order to reduce damage to the processed substrate. Furthermore, in order to improve removability of the resist and the resist underlayer film, a basic organic solvent is used. However, the resist underlayer film has limitations in the prior art in that it exhibits removability, and preferably solubility, only in a wet etching chemical liquid, while mainly exhibiting excellent resistance to a resist solvent, which is an organic solvent, or a resist developer, which is an alkaline aqueous solution. An object of the present invention is to solve the above problems.

### Solution to Problem

As a result of intensive studies to solve the above problems, the present inventors have found that a film obtained using a resist underlayer film-forming composition containing a curcumin derivative exhibits excellent resistance to a resist solvent or a resist developer which is an alkaline aqueous solution, and exhibits excellent removability (solubility) in a wet etching chemical liquid, thereby completing the present invention.

That is, the present invention includes the following aspects.
[1] A resist underlayer film-forming composition containing: at least any one of a compound having a partial structure represented by Formula (1) or a polymer having a partial structure represented by Formula (1); and a solvent, 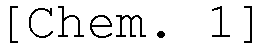 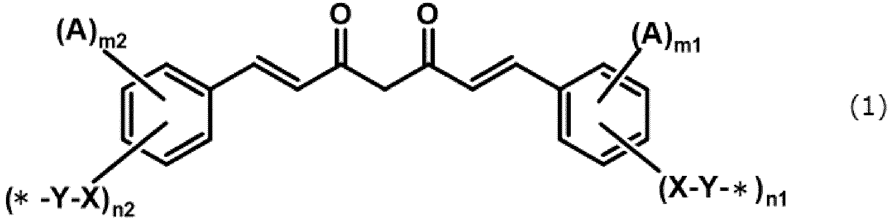 wherein each -X- independently represents -O-, -S-, - NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.
[2] The resist underlayer film-forming composition according to [1], wherein
   the compound having a partial structure represented by Formula (1) or the polymer having the partial structure represented by Formula (1) is
   a reaction product of a compound represented by any one of Formulae (A-1) to (A-4) and a mono-, bi-, or polyfunctional epoxy compound,
   a reaction product of a compound represented by any one of Formulae (A-1) to (A-3) and a mono-, bi-, or polyfunctional carboxylic acid,
   a reaction product of a compound represented by Formula (A-4) and a monovalent, divalent, or multivalent alcohol, or a phenol or polyphenol having one or two or more phenolic hydroxyl groups, or
   a reaction product of a compound represented by Formula (A-4) and a monovalent, divalent, or multivalent thiol, or a thiophenol or polythiophenol having one or two or more thiophenolic mercapto groups, 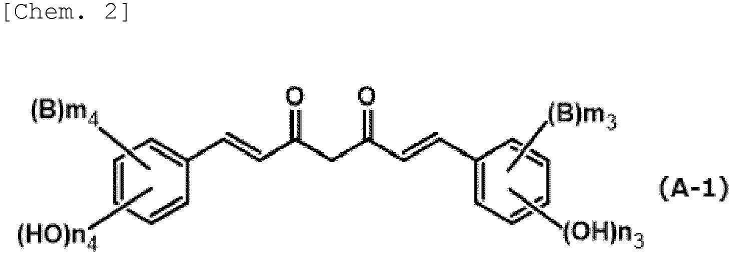 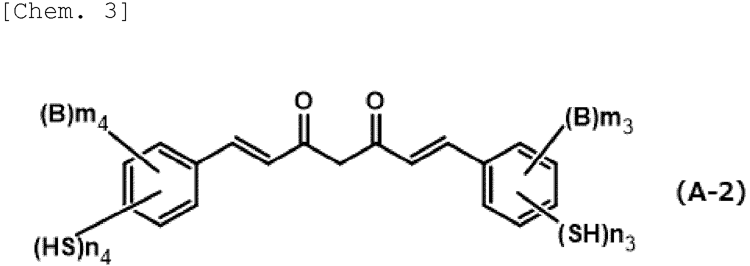 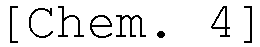 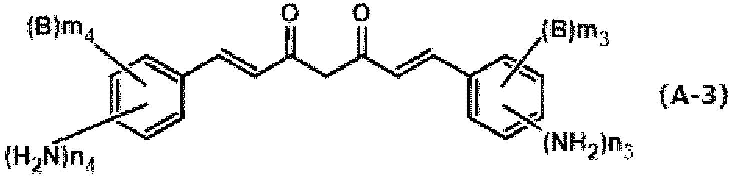 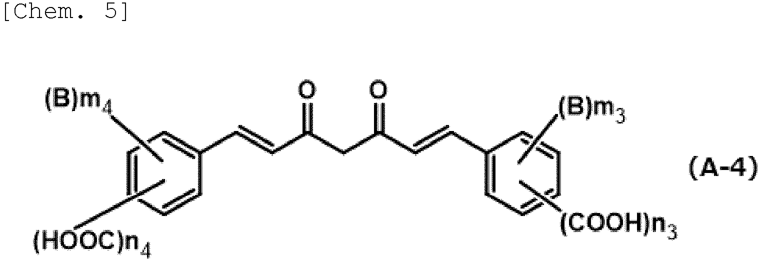
   wherein each B independently represents an alkyl group, a halogen atom, or an alkoxy group; n₃ satisfies 1 ≤ n₃ ≤ 5, m₃ satisfies 0 ≤ m₁ ≤ 4, and n₃ and m₃ satisfy n₃ + m₃ ≤ 5; and n₄ satisfies 1 ≤ n₄ ≤ 5, m₄ satisfies 0 ≤ m₄ ≤ 4, and n₄ and m₄ satisfy n₄ + m₄ ≤ 5.
[3] The resist underlayer film-forming composition according to [1] or [2], wherein
   the compound having a partial structure represented by Formula (1) is a compound represented by Formula (2-1), a compound represented by Formula (2-2), a compound represented by Formula (2-3), or a compound represented by Formula (2-4), and
   the polymer having the partial structure represented by Formula (1) is a polymer having a repeating unit represented by Formula (3-1), a polymer having a repeating unit represented by Formula (3-2), a polymer having a repeating unit represented by Formula (3-3), or a polymer having a repeating unit represented by Formula (3-4), 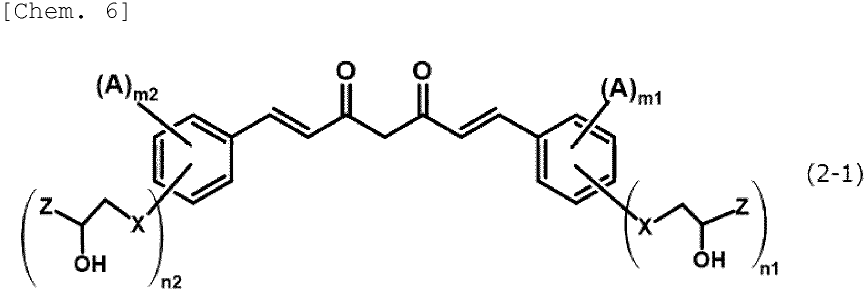
   wherein each -Z independently represents -L₁, -CH₂OH, - CH₂OL₁, or -CH₂OC(=O)L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 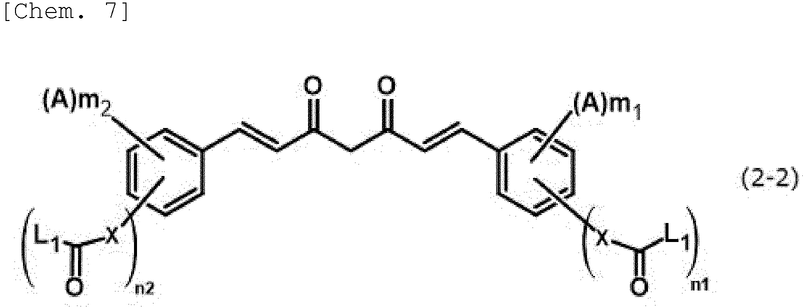
   wherein each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 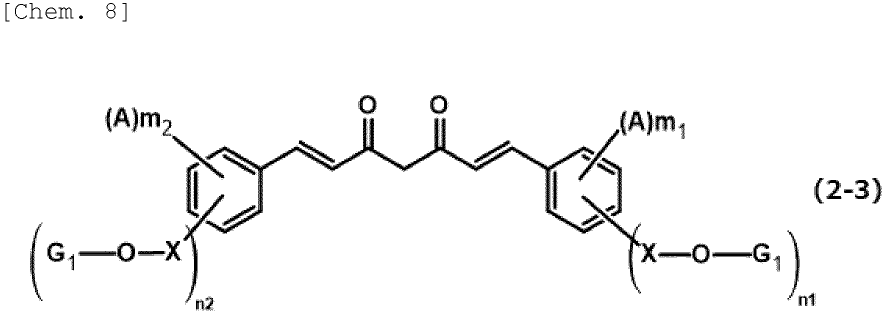
   wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 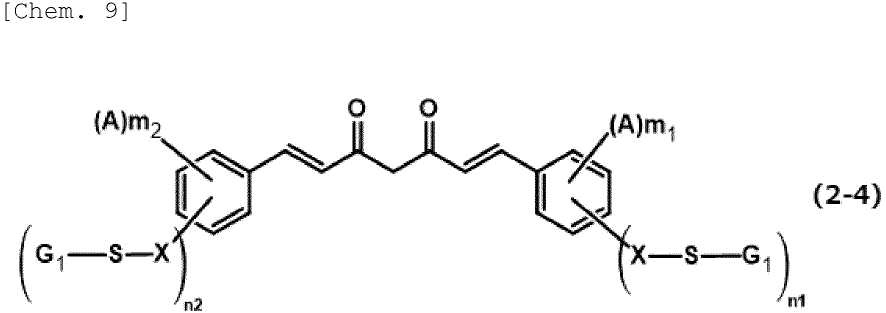
   wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 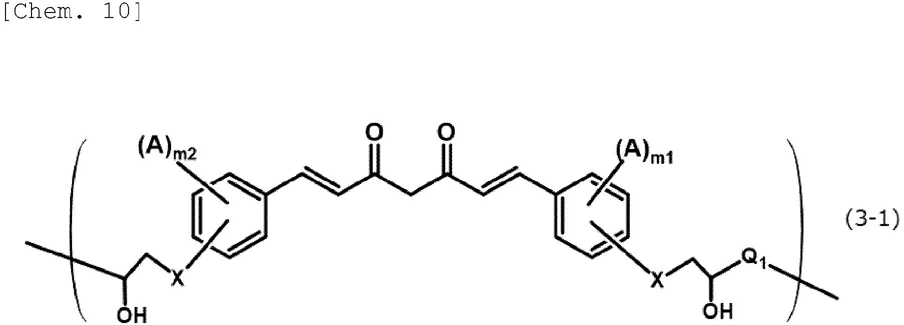
   wherein -Q₁- represents -T₁-, -CH₂O-T₁-O-CH₂-, -CH₂OCH₂-T₁-CH₂OCH₂-, or -CH₂OC(=O)-T₁-C(=O)OCH₂-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 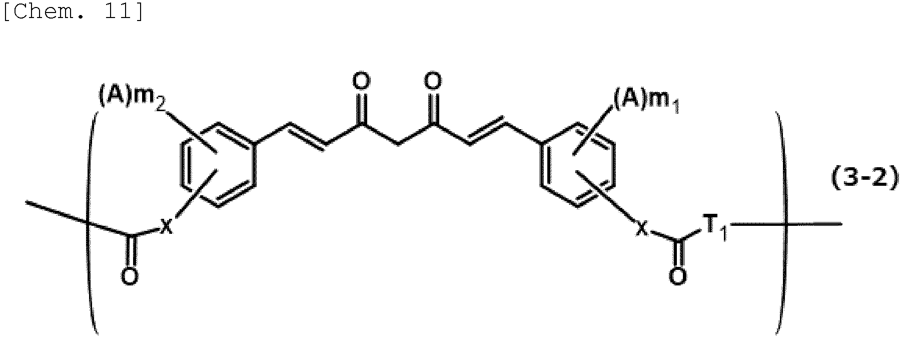
   wherein T₁ represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 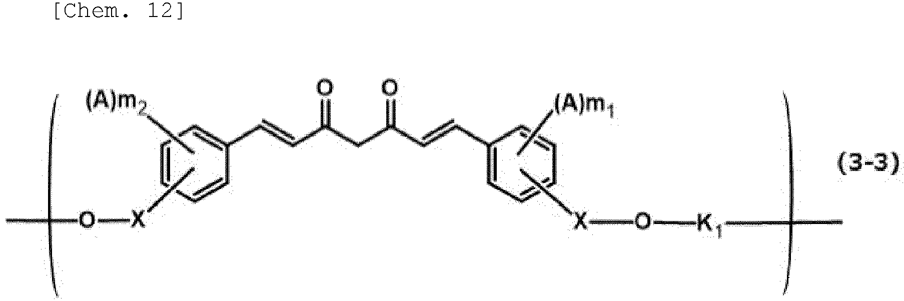
   wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 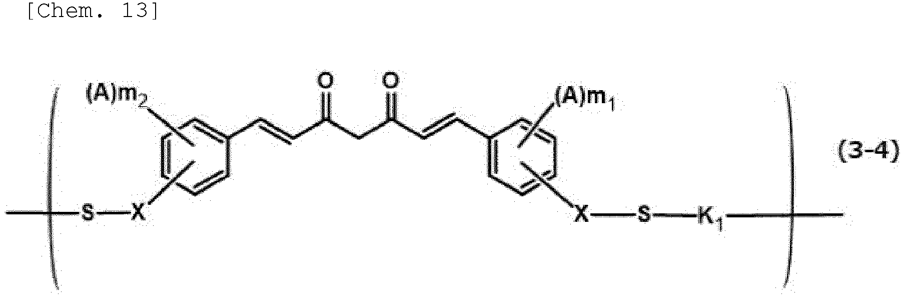
   wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4.
[4] The resist underlayer film-forming composition according to any one of [1] to [3], further containing at least one selected from the group consisting of a crosslinking agent, an acid, and an acid generator.
[5] The resist underlayer film-forming composition according to any one of [1] to [4], wherein the resist underlayer film-forming composition is applied onto a substrate containing copper on a surface of the substrate.
[6] A resist underlayer film obtained by removing a solvent from a coating film containing the resist underlayer film-forming composition according to any one of [1] to [4].
[7] A resist underlayer film containing the resist underlayer film-forming composition according to any one of [1] to [4], the resist underlayer film-forming composition being baked, dried, or concentrated.
[8] The resist underlayer film according to [6] or [7], wherein the resist underlayer film is formed on a substrate containing copper on a surface of the substrate.
[9] A substrate including: a copper seed layer; and the resist underlayer film according to [6] or [7] formed on the copper seed layer, wherein the copper seed layer and the resist underlayer film are formed on a surface of the substrate.
[10] A method for manufacturing a substrate including a patterned resist film, the method including:
   a step of applying the resist underlayer film-forming composition according to any one of [1] to [4] onto a surface of a substrate, in which the surface contains copper, and baking the resist underlayer film-forming composition to form a resist underlayer film;
   a step of applying a resist onto the resist underlayer film and baking the resist to form a resist film;
   a step of exposing a semiconductor substrate coated with the resist underlayer film and the resist; and
   a step of developing the resist film after the exposing, and performing patterning.
[11] A method for manufacturing a semiconductor device, the method including:
   a step of forming a resist underlayer film containing the resist underlayer film-forming composition according to any one of [1] to [4] on a substrate containing copper on a surface of the substrate;
   a step of forming a resist film on the resist underlayer film;
   a step of irradiating the resist film with light or an electron beam and developing the resist film to form a resist pattern, and subsequently removing the resist underlayer film exposed between the resist patterns;
   a step of performing copper plating between the formed resist patterns; and
   a step of removing the resist patterns and the resist underlayer film existing under the resist patterns.
[12] The method for manufacturing a semiconductor device according to [11], wherein at least one of the steps of removing the resist underlayer film is performed by wet processing.
[13] A compound having a partial structure represented by Formula (1), 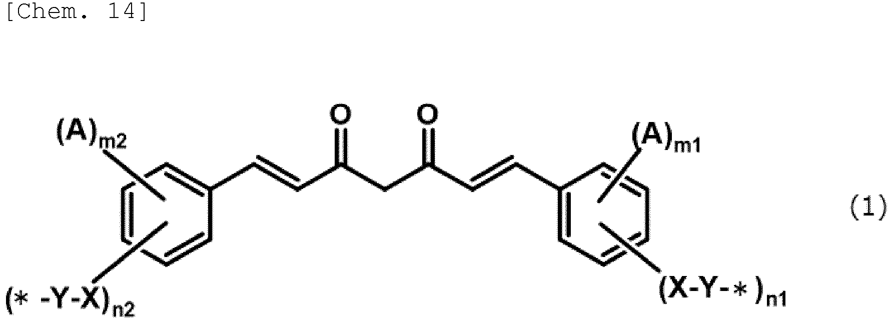 wherein each -X- independently represents -O-, -S-, - NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.
[14] The compound according to [13], wherein the compound having a partial structure represented by Formula (1) is a compound represented by Formula (2-1), a compound represented by Formula (2-2), a compound represented by Formula (2-3), or a compound represented by Formula (2-4), 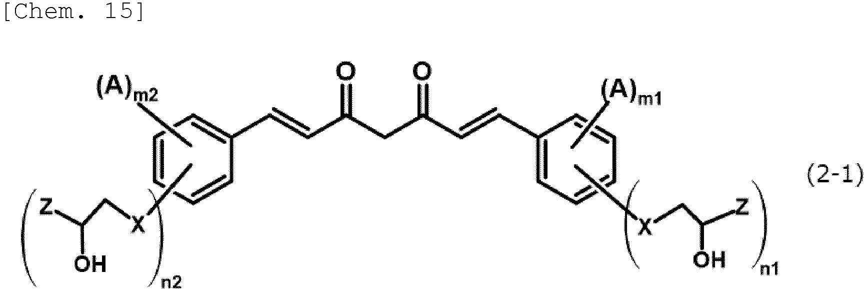 wherein each -Z independently represents -L₁, -CH₂OH, - CH₂OL₁, or -CH₂OC(=O)L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 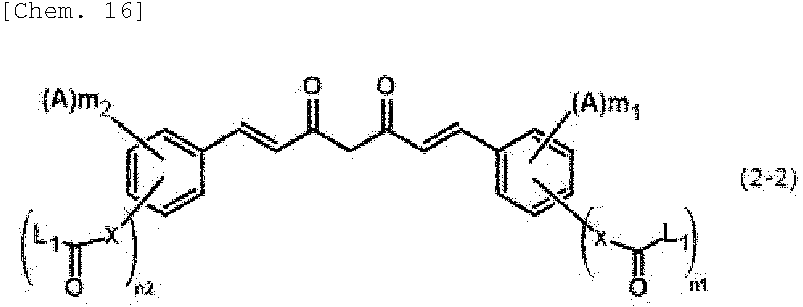 wherein each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 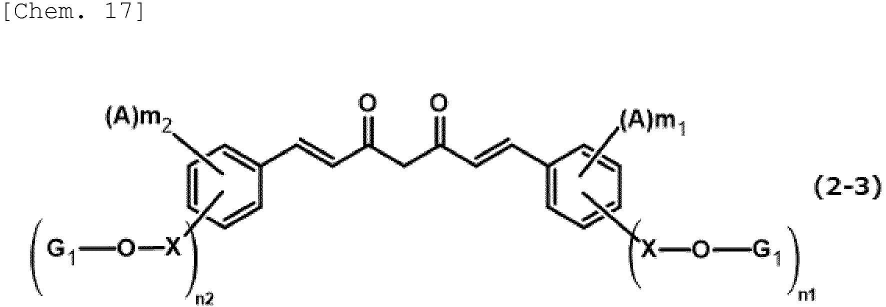 wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 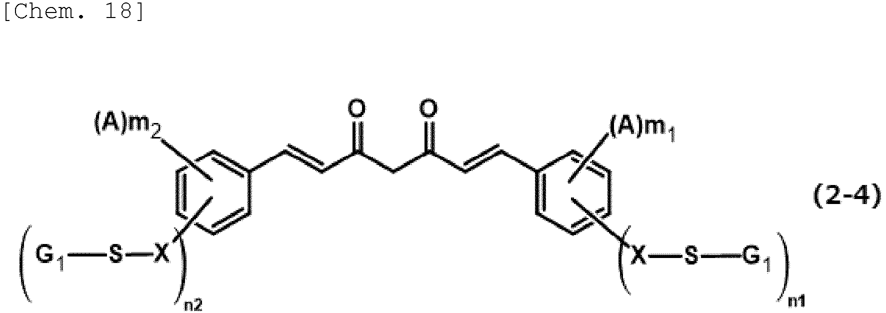 wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1).
[15] A polymer having a partial structure represented by Formula (1), 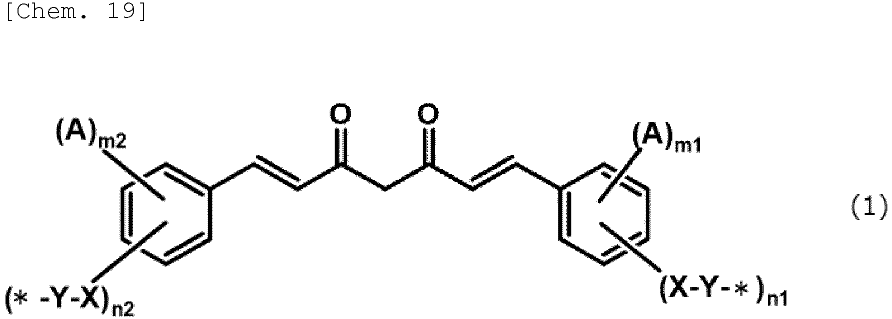 wherein each -X- independently represents -O-, -S-, - NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.
[16] The polymer according to [15], wherein the polymer having the partial structure represented by Formula (1) is a polymer having a repeating unit represented by Formula (3-1), a polymer having a repeating unit represented by Formula (3-2), a polymer having a repeating unit represented by Formula (3-3), or a polymer having a repeating unit represented by Formula (3-4), 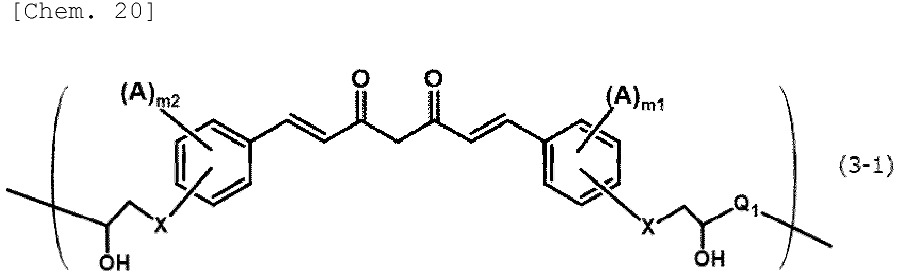 wherein -Q₁- represents -T₁-, -CH₂O-T₁-O-CH₂-, -CH₂OCH₂-T₁-CH₂OCH₂-, or -CH₂OC(=O)-T₁-C(=O)OCH₂-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 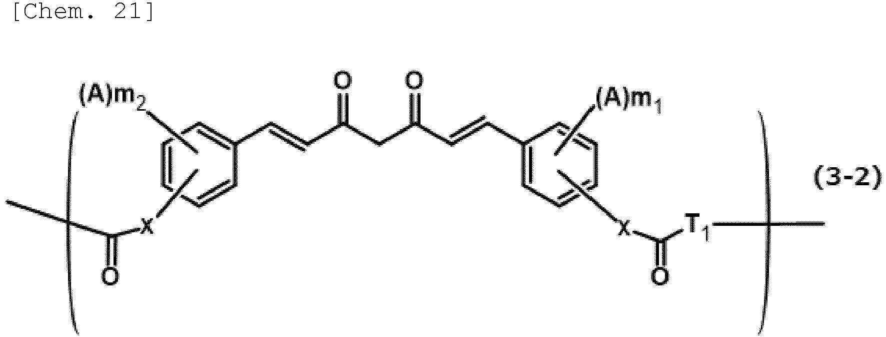 wherein T₁ represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 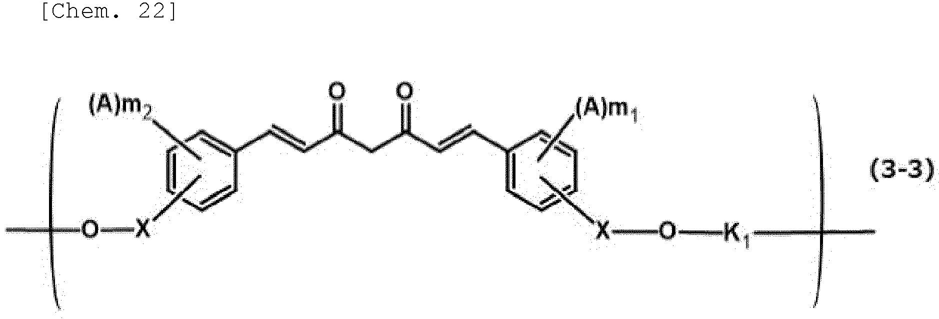 wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 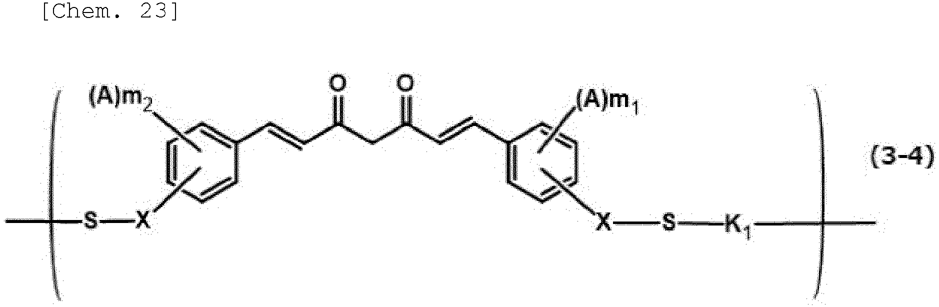 wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4.

### Advantageous Effects of Invention

According to the present invention, it is possible to provide a resist underlayer film that exhibits excellent removability (solubility) in a wet etching chemical liquid while mainly exhibiting excellent resistance to a resist solvent, which is an organic solvent, or a resist developer, which is an alkaline aqueous solution.

### Description of Embodiments

Hereinafter, the present invention will be described in detail. Note that the description of the constituent elements described below is an example for describing the present invention, and the present invention is not limited to these contents.

### (Resist Underlayer Film-Forming Composition)

A resist underlayer film-forming composition of the present invention contains at least any one of a compound having a partial structure (hereinbelow, also referred to as a specific partial structure) represented by Formula (1) or a polymer having a partial structure represented by Formula (1), and a solvent.

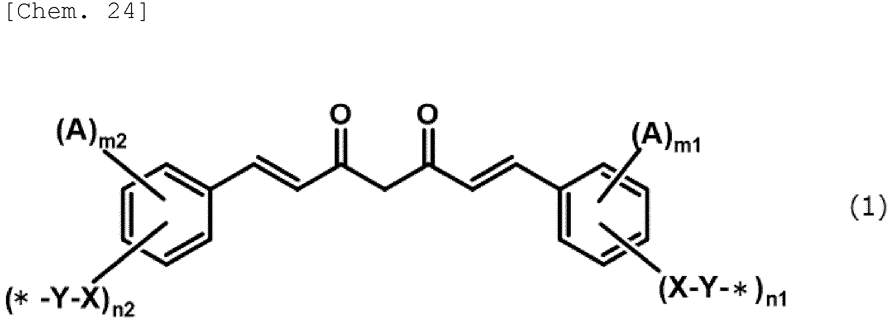

In Formula (1), each -X- independently represents -O-, -S-, -NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; and n₂ satisfies 1 ≤ n₂ ≤ 5, m₂ satisfies 0 ≤ m₂ ≤ 4, and n₂ and m₂ satisfy n₂ + m₂ ≤ 5. * represents a bond.

The resist underlayer film-forming composition of the present invention can further contain at least any one of the compound having a specific partial structure or the polymer having a specific partial structure, and at least one selected from the group consisting of a crosslinking agent, an acid, and an acid generator, or other components, in addition to the solvent.

### <Compound Having Specific Partial Structure>

In the partial structure represented by Formula (1), - X- is preferably -O- out of -O-, -S-, -NH-, -C(=O)O-, or - C(=O)-.

In Formula (1), for example, when -X- is -O-, -S-, or - NH-, -Y- is -CH₂CH(OH)- or -C(=O)-.

In addition, in Formula (1), for example, when -X- is - C(=O)O-, -Y- is -CH₂CH(OH)-.

In addition, in Formula (1), for example, when -X- is - C(=O)-, -Y- is -O- or -S-.

The alkyl group in A in Formula (1) is preferably, for example, an alkyl group having 1 to 10 carbon atoms, and the alkoxy group is preferably, for example, an alkoxy group having 1 to 10 carbon atoms.

Examples of the alkyl group having 1 to 10 carbon atoms include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, and a decyl group.

Examples of the alkoxy group having 1 to 10 carbon atoms include a group in which an oxygen atom is bonded to the alkyl group. Examples thereof include a methoxy group, an ethoxy group, an n-propoxy group, an i-propoxy group, an n-butoxy group, an i-butoxy group, an s-butoxy group, a t-butoxy group, an n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, a 1-ethyl-2-methyl-n-propoxy group, an n-heptyloxy group, an n-octyloxy group, an n-nonyloxy group, and an n-decanyloxy group.

Examples of the halogen atom in Formula (1) include a fluorine atom, a chlorine atom, a bromine atom, and an iodine atom.

The compound having a partial structure represented by Formula (1) is, for example:
· a reaction product of a compound represented by any one of Formulae (A-1) to (A-4) and a monofunctional epoxy compound;
· a reaction product of a compound represented by any one of Formulae (A-1) to (A-3) and a monofunctional carboxylic acid;
· a reaction product of a compound represented by Formula (A-4) and a monovalent alcohol or phenol having one phenolic hydroxyl group; or
· a reaction product of a compound represented by Formula (A-4) and a monovalent thiol, or thiophenol having one thiophenolic mercapto group.

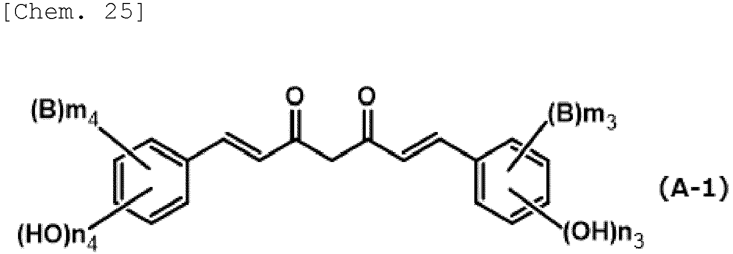

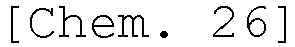

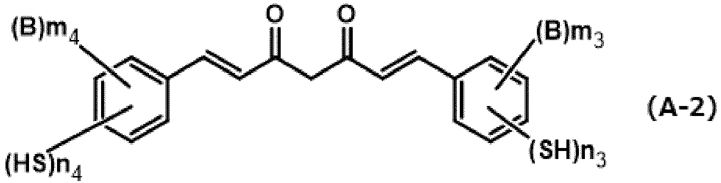

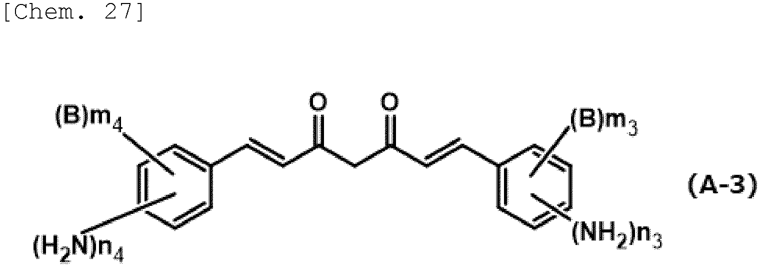

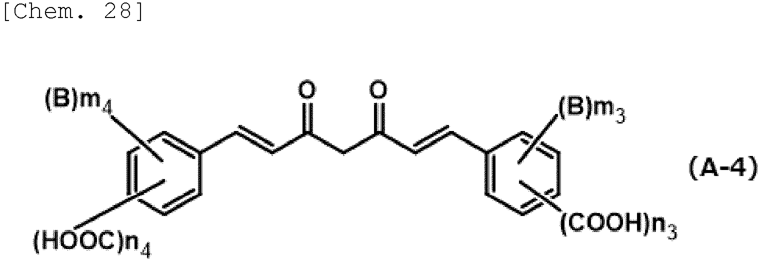

In Formulae (A-1) to (A-4), each B independently represents an alkyl group, a halogen atom, or an alkoxy group; n₃ satisfies 1 ≤ n₃ ≤ 5, m₃ satisfies 0 ≤ m₁ ≤ 4, and n₃ and m₃ satisfy n₃ + m₃ ≤ 5; and n₄ satisfies 1 ≤ n₄ ≤ 5, m₄ satisfies 0 ≤ m₄ ≤ 4, and n₄ and m₄ satisfy n₄ + m₄ ≤ 5.

Examples of the compound having a specific partial structure represented by Formula (1) include a compound represented by Formula (2-1), a compound represented by Formula (2-2), a compound represented by Formula (2-3), and a compound represented by Formula (2-4).

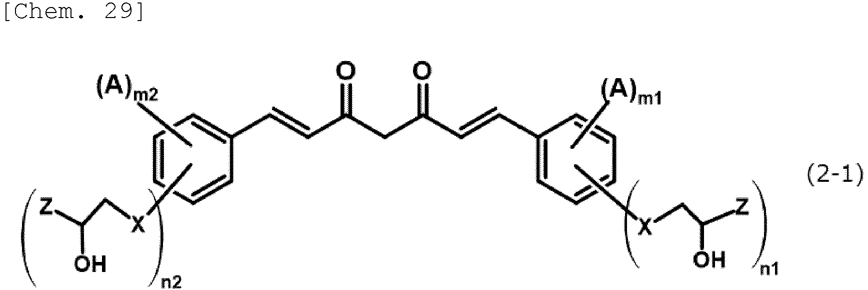

In Formula (2-1), each -Z independently represents -L₁, -CH₂OH, -CH₂OL₁, or -CH₂OC(=O)L₁. Each L₁ independently represents a monovalent acyclic group or a monovalent group having a cyclic structure. -X- and A are identical to -X- and A in Formula (1). n₁, m₁, n₂, and m₂ are also identical to n₁, m₁, n₂, and m₂ in Formula (1).

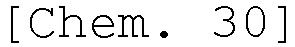

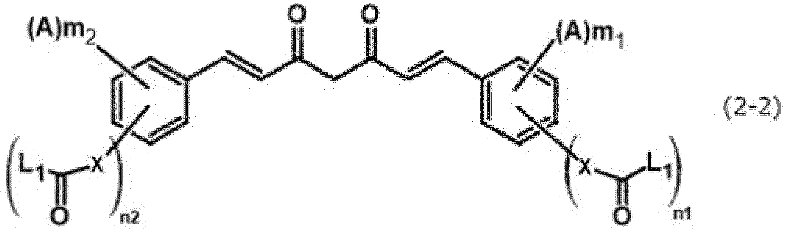

In Formula (2-2), each L₁ independently represents a monovalent acyclic group or a monovalent group having a cyclic structure. -X- and A are identical to -X- and A in Formula (1). n₁, m₁, n₂, and m₂ are also identical to n₁, m₁, n₂, and m₂ in Formula (1).

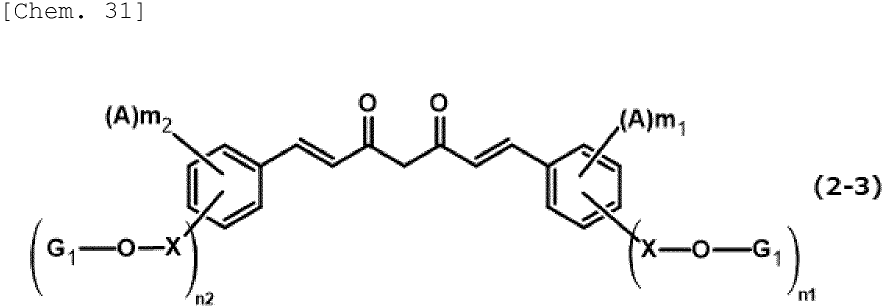

In Formula (2-3), each -G₁ independently represents - CH₂L₁ or -C₆H₄L₁. Each L₁ independently represents a monovalent acyclic group or a monovalent group having a cyclic structure. -X- and A are identical to -X- and A in Formula (1). n₁, m₁, n₂, and m₂ are also identical to n₁, m₁, n₂, and m₂ in Formula (1).

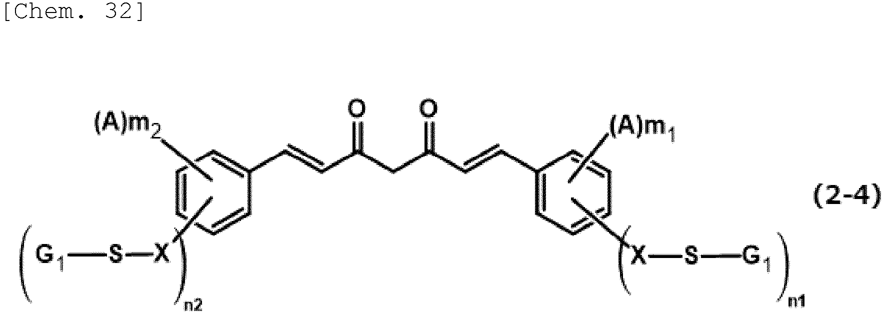

In Formula (2-4), each -G₁ independently represents - CH₂L₁ or -C₆H₄L₁. Each L₁ independently represents a monovalent acyclic group or a monovalent group having a cyclic structure. -X- and A are identical to -X- and A in Formula (1). n₁, m₁, n₂, and m₂ are also identical to n₁, m₁, n₂, and m₂ in Formula (1).

In Formula (2-1), each -Z independently represents -L₁, -CH₂OH, -CH₂OL₁, or -CH₂OC(=O)L₁, where each L₁ independently represents a monovalent acyclic group or a monovalent group having a cyclic structure, as described above.

The monovalent acyclic group in L₁ of Formula (2-1) refers to a monovalent group containing no cyclic structure, and examples thereof include a monovalent acyclic hydrocarbon group having 1 to 20 carbon atoms which may be interrupted by an oxygen atom or a sulfur atom.

Examples of the monovalent acyclic hydrocarbon group having 1 to 20 carbon atoms include an alkyl group having 1 to 20 carbon atoms (preferably, an alkyl group having 1 to 6 carbon atoms), -CH₂CH₂-(OCH₂CH₂)ₙ (n represents an integer of 1 to 9), and -CH(CH₃)CH₂-(OCH(CH₃)CH₂)ₙ (n represents an integer of 1 to 5).

The alkyl group having 1 to 20 carbon atoms may be linear or branched.

The monovalent group having a cyclic structure in L₁ of Formula (2-1) refers to, for example, a monovalent organic group having a cyclic structure which may have a substituent, and examples thereof include a monovalent organic group having an aromatic hydrocarbon ring or aliphatic hydrocarbon ring which may have a substituent, and a monovalent organic group having a heterocyclic ring (heterocycle) containing a hetero atom such as oxygen, nitrogen, or sulfur other than carbon as a constituent element of the ring.

Specific examples of the aromatic hydrocarbon ring in L₁ of Formula (2-1) include benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, and dibenzo[a,j]anthracene.

Specific examples of the heterocyclic ring in L₁ of Formula (2-1) include furan, thiophene, pyrrole, imidazole, pyran, pyridine, pyrimidine, pyrazine, pyrrolidine, piperidine, piperazine, morpholine, quinuclidine, indole, purine, thymine, quinoline, isoquinoline, chromene, thianthrene, phenothiazine, phenoxazine, xanthene, acridine, phenazine, carbazole, hydantoin, uracil, barbituric acid, triazine, and cyanuric acid. The heterocyclic ring may be triazinetrione, dioxoimidazoline, or diazinetrione.

Examples of the substituent in the cyclic structure which may have a substituent in L₁ of Formula (2-1) include a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, and an aralkyl group having 7 to 13 carbon atoms.

Examples of a preferable embodiment of the monovalent organic group having an aromatic hydrocarbon ring or aliphatic hydrocarbon ring in L₁ of Formula (2-1) include a monovalent organic group represented by Formula (2-5-1), a monovalent organic group represented by Formula (2-5-2), a monovalent organic group represented by Formula (2-5-3), and a monovalent organic group represented by Formula (2-5-4) .

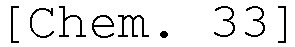

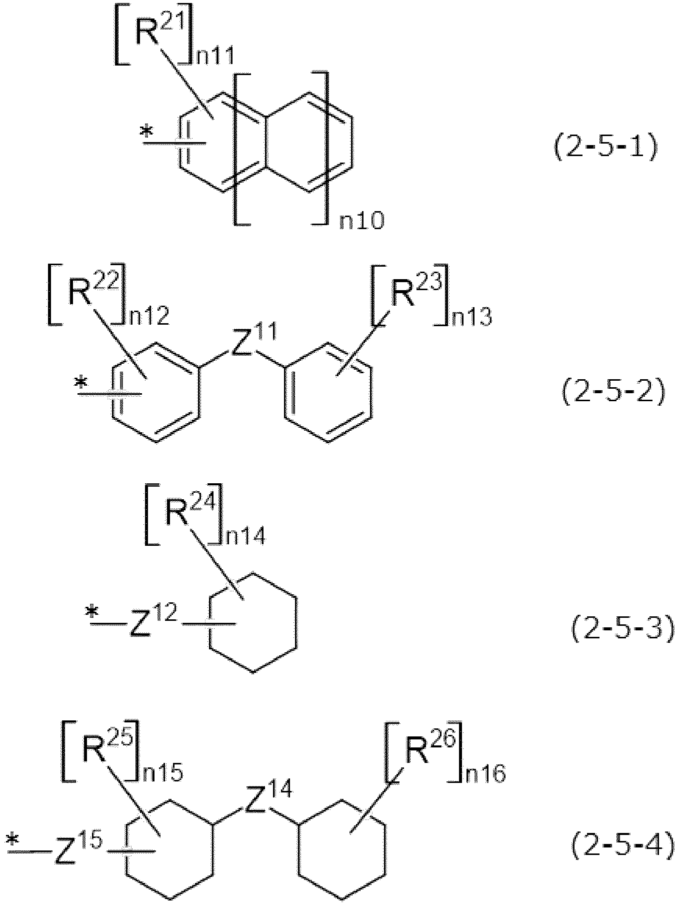

(In Formulae (2-5-1) to (2-5-4), R²¹ to R²⁶ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms. * represents a bond.

In Formula (2-5-1), n10 represents 0 or 1. When n10 is 0, n11 represents an integer of 0 to 5. When n10 is 1, n11 represents an integer of 0 to 7. When two or more R²¹s are present, the two or more R²¹s may be identical to or different from each other.

In Formula (2-5-2), Z¹¹ represents a single bond, an oxygen atom, a sulfur atom, a carbonyl group, a sulfonyl group, or an alkylene group having 1 to 6 carbon atoms. n12 represents an integer of 0 to 4. n13 represents an integer of 0 to 5. When two or more R²²s are present, the two or more R²²s may be identical to or different from each other. When two or more R²³s are present, the two or more R²³s may be identical to or different from each other.

In Formula (2-5-3), Z¹² represents a single bond or a linear or branched alkylene group having 1 to 6 carbon atoms. n14 represents an integer of 0 to 5. When two or more R²⁴s are present, the two or more R²⁴s may be identical to or different from each other.

In Formula (2-5-4), Z¹⁴ represents a single bond, an oxygen atom, a sulfur atom, a carbonyl group, a sulfonyl group, or an alkylene group having 1 to 6 carbon atoms. Z¹⁵ each independently represents a single bond or a linear or branched alkylene group having 1 to 6 carbon atoms. n15 represents an integer of 0 to 4. n16 represents an integer of 0 to 5. When two or more R²⁵s are present, the two or more R²⁵s may be identical to or different from each other. When two or more R²⁶s are present, the two or more R²⁶s may be identical to or different from each other.)

The preferable embodiment of the monovalent organic group having a heterocyclic ring in L₁ of Formula (2-1) include a monovalent organic group represented by Formula (2-6) .

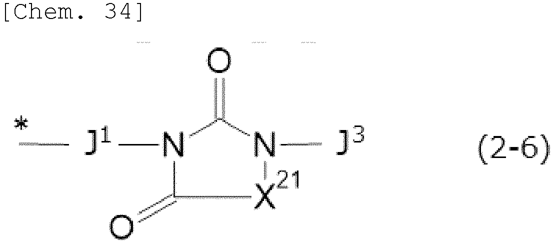

In Formula (2-6), X²¹ represents a divalent group represented by any one of following Formulae (2-6-1) to (2-6-3). J¹ represents a single bond or a divalent group represented by Formula (2-6-5). J³ represents a hydrogen atom or a monovalent group represented by Formula (2-6-6).)

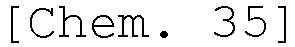

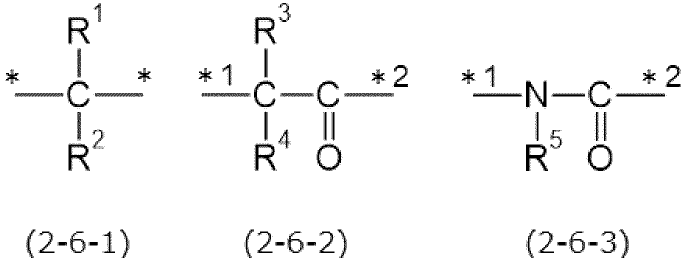

(In Formulae (2-6-1) to (2-6-3), R¹ to R⁵ each independently represent a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, where the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms. R¹ and R² may be bonded to each other to form a ring having 3 to 6 carbon atoms. R³ and R⁴ may be bonded to each other to form a ring having 3 to 6 carbon atoms.
* represents a bond. *1 represents a bond bonded to a carbon atom in Formula (2-6). *2 represents a bond bonded to a nitrogen atom in Formula (2-6).)

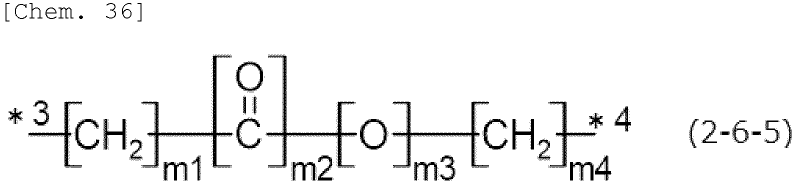

(In Formula (2-6-5), m1 is an integer of 0 to 4, m2 is 0 or 1, m3 is 0 or 1, and m4 is an integer of 0 to 2, where, in a case where m3 is 1, m1 and m2 are not simultaneously 0. *3 represents a bond bonded to a nitrogen atom in Formula (2-6). *4 represents a bond.)

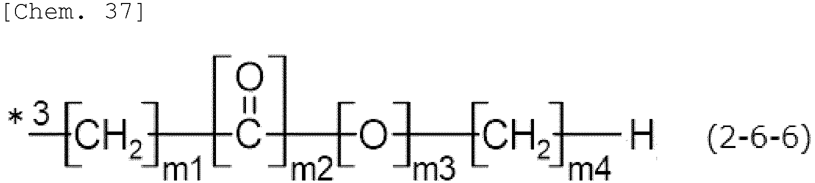

(In Formula (2-6-6), m1 is an integer of 0 to 4, m2 is 0 or 1, m3 is 0 or 1, and m4 is an integer of 0 to 2, where, in a case where m3 is 1, m1 and m2 are not simultaneously 0. *3 represents a bond bonded to a nitrogen atom in Formula (2-6).)

L₁ in Formula (2-2) is also the same as L₁ in Formula (2-1).

L₁ in Formula (2-3) is also the same as L₁ in Formula (2-1).

L₁ in Formula (2-4) is also the same as L₁ in Formula (2-1) .

### <<Method for Producing Compound Having Specific Partial Structure>>

### <<Method for Producing Compound Represented by Formula (2-1)>>

Among the compounds, each having a specific partial structure, for example, the compound represented by Formula (2-1) can be obtained by reacting a compound represented by any one of Formulae (A-1) to (A-4) and a monofunctional epoxy compound, but the reaction method is not particularly limited, and the compound can be produced using a known method. For example, the production can be carried out by a method described in Examples described later.

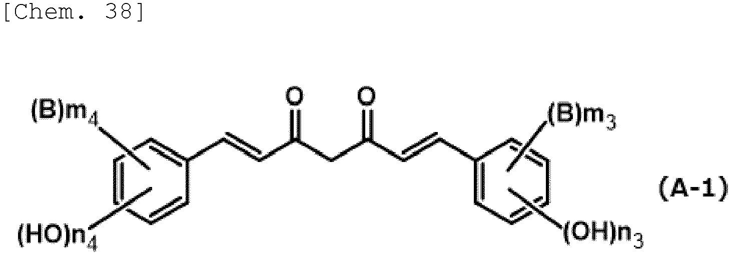

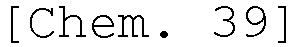

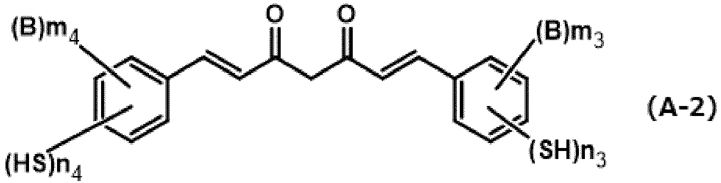

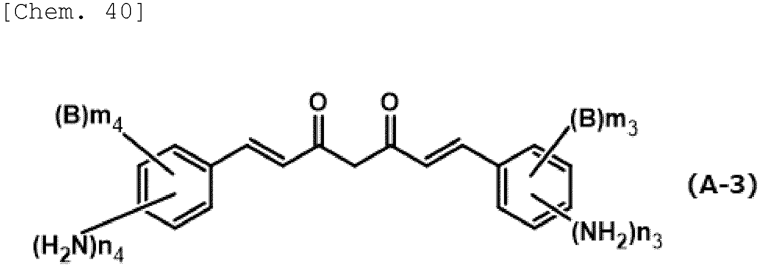

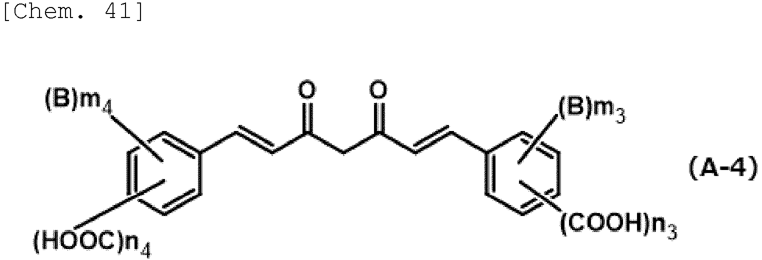

In Formulae (A-1) to (A-4), each B independently represents an alkyl group, a halogen atom, or an alkoxy group; n₃ satisfies 1 ≤ n₃ ≤ 5, m₃ satisfies 0 ≤ m₁ ≤ 4, and n₃ and m₃ satisfy n₃ + m₃ ≤ 5; and n₄ satisfies 1 ≤ n₄ ≤ 5, m₄ satisfies 0 ≤ m₄ ≤ 4, and n₄ and m₄ satisfy n₄ + m₄ ≤ 5.

Examples of the compound represented by Formula (A-1) include compounds represented by Formulae (A-11) to (A-16).

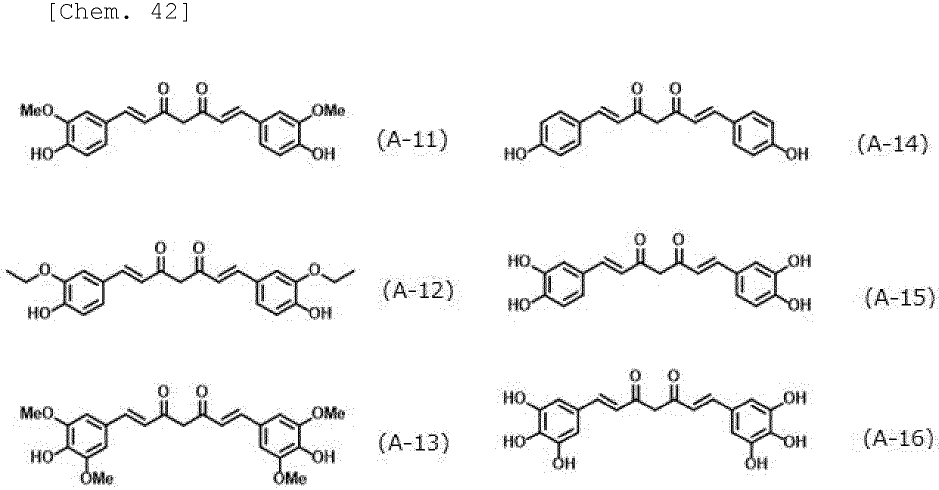

In Formulae (A-11) and (A-13), OMe represents a methoxy group.

Examples of the monofunctional epoxy compound include an epoxy compound represented by Formula (B).

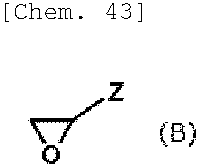

In Formula (B), -Z represents -L₁, -CH₂OH, -CH₂OL₁, or - CH₂OC(=O)L₁ as in Formula (2-1). L₁ represents a monovalent acyclic group or a monovalent group having a cyclic structure.

Examples of the monofunctional epoxy compound represented by Formula (B) include monofunctional epoxy compounds represented by the following structural formulae.

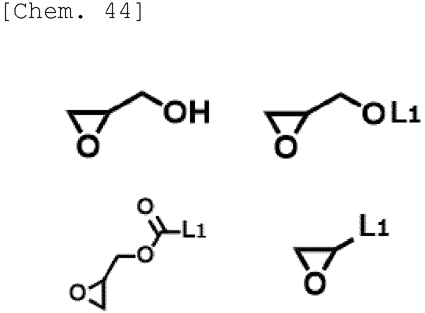

L₁ represents a monovalent acyclic group or a monovalent group having a cyclic structure as in Formula (2-1).

Examples of the method for producing the compound represented by Formula (2-1) include a production method in which each of compounds shown below is reacted with a monofunctional epoxy compound.

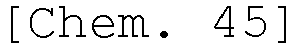

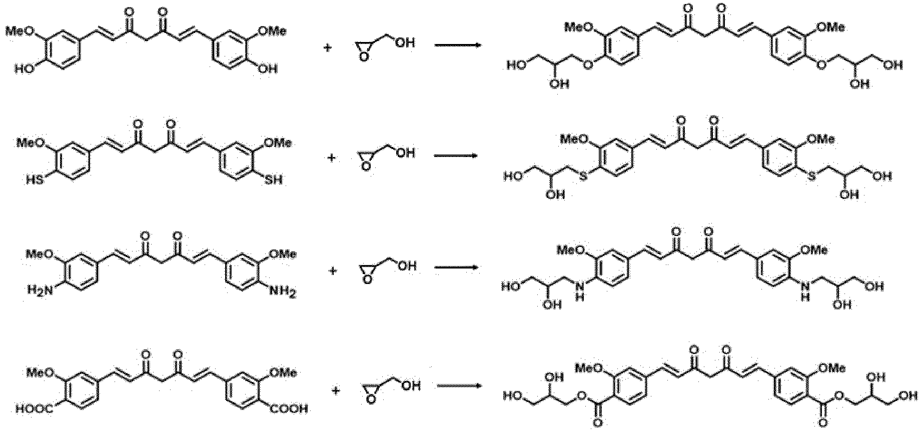

### <<Method for Producing Compound Represented by Formula (2-2)>>

Among the compounds, each having a specific partial structure, for example, the compound represented by Formula (2-2) can be obtained by reacting a compound represented by any one of Formulae (A-1) to (A-3) and a monofunctional carboxylic acid, but the reaction method is not particularly limited, and the compound can be produced using a known method.

Examples of the monofunctional carboxylic acid include a carboxylic acid represented by Formula (C).

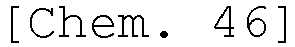

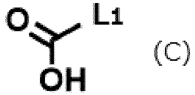

In Formula (C), L₁ represents a monovalent acyclic group or a monovalent group having a cyclic structure as in Formula (2-2).

Examples of the method for producing the compound represented by Formula (2-2) include a production method in which each of compounds shown below is reacted with a monofunctional carboxylic acid.

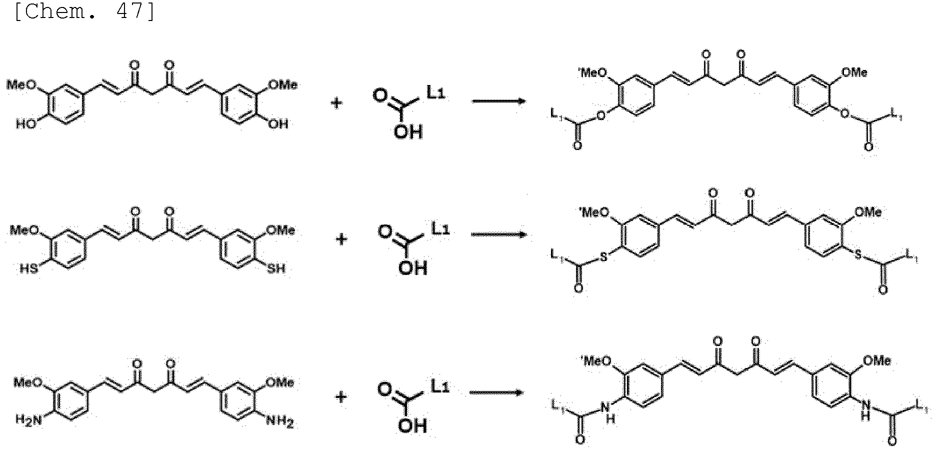

### <<Method for Producing Compound Represented by Formula (2-3)>>

Among the compounds, each having a specific partial structure, for example, the compound represented by Formula (2-3) can be obtained by reacting the compound represented by Formula (A-4) and a monovalent alcohol or a phenol having one phenolic hydroxyl group (monovalent phenol), but the reaction method is not particularly limited, and the compound can be produced using a known method.

Examples of the monovalent alcohol or monovalent phenol include an alcohol or phenol represented by Formula (D).
[Chem. 48]

(D) **G₁-OH**

In Formula (D), -G₁ represents -CH₂L₁ or -C₆H₄L₁ as in Formula (2-3). L₁ represents a monovalent acyclic group or a monovalent group having a cyclic structure.

Examples of the monovalent alcohol or monovalent phenol represented by Formula (D) include compounds represented by the following structural formulae.

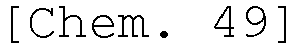

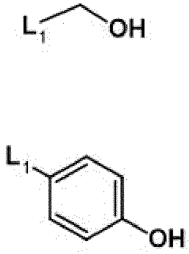

L₁ represents a monovalent acyclic group or a monovalent group having a cyclic structure as in Formula (2-1).

Examples of the method for producing the compound represented by Formula (2-3) include a production method in which each of compounds shown below is reacted with a monovalent alcohol or monovalent phenol.

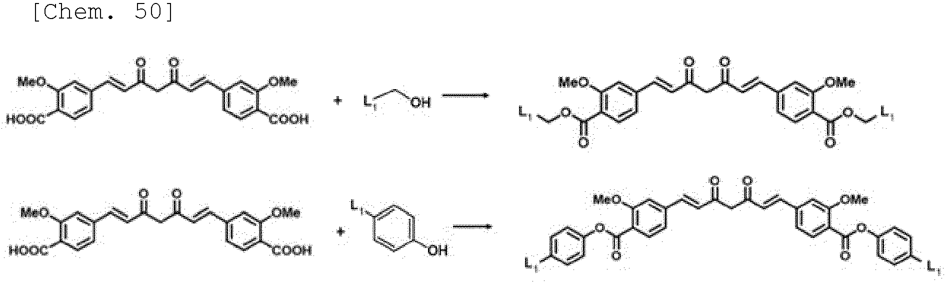

### <<Method for Producing Compound Represented by Formula (2-4)>>

Among the compounds, each having a specific partial structure, for example, the compound represented by Formula (2-4) can be obtained by reacting the compound represented by Formula (A-4) and a monovalent thiol or a thiophenol having one thiophenolic mercapto group (monovalent thiophenol), but the reaction method is not particularly limited, and the compound can be produced using a known method.

Examples of the monovalent thiol or monovalent thiophenol include a thiol or thiophenol represented by Formula (E).

[Chem. 51] **G₁-SH (E)**

In Formula (E), -G₁ represents -CH₂L₁ or -C₆H₄L₁ as in Formula (2-4). L₁ represents a monovalent acyclic group or a monovalent group having a cyclic structure.

Examples of the monovalent thiol or monovalent thiophenol represented by Formula (E) include compounds represented by the following structural formulae.

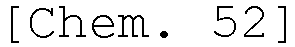

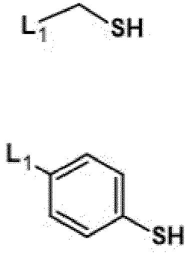

L₁ represents a monovalent acyclic group or a monovalent group having a cyclic structure as in Formula (2-1).

Examples of the method for producing the compound represented by Formula (2-4) include a production method in which each of compounds shown below is reacted with a monovalent thiol or monovalent thiophenol.

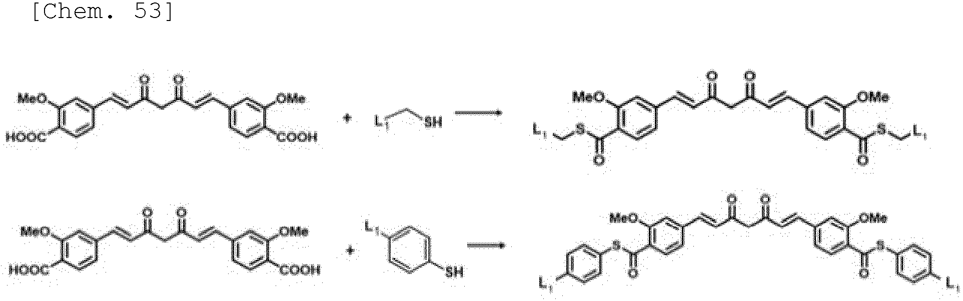

### <Polymer Having Specific Partial Structure>

In the partial structure represented by Formula (1), - X- is preferably -O- out of -O-, -S-, -NH-, -C(=O)O-, or - C(=O)-.

In Formula (1), for example, when -X- is -O-, -S-, or - NH-, -Y- is -CH₂CH(OH)- or -C(=O)-.

In addition, in Formula (1), for example, when -X- is - C(=O)O-, -Y- is -CH₂CH(OH)-.

In addition, in Formula (1), for example, when -X- is - C(=O)-, -Y- is -O- or -S-.

The alkyl group in A in Formula (1) is preferably, for example, an alkyl group having 1 to 10 carbon atoms, and the alkoxy group is preferably, for example, an alkoxy group having 1 to 10 carbon atoms.

The alkyl group having 1 to 10 carbon atoms and the alkoxy group having 1 to 10 carbon atoms are as described in the above section of <Compound Having Specific Partial Structure>.

The halogen atom in Formula (1) is as described in the above section of <Compound Having Specific Partial Structure>.

The polymer having the partial structure represented by Formula (1) is, for example,
· a reaction product of a compound represented by any one of Formulae (A-1) to (A-4) and a bi- or polyfunctional epoxy compound,
· a reaction product of a compound represented by any one of Formulae (A-1) to (A-3) and a bi- or polyfunctional carboxylic acid,
· a reaction product of a compound represented by Formula (A-4) and a divalent alcohol or polyphenol having two or more phenolic hydroxyl groups; or
· a reaction product of a compound represented by Formula (A-4) and a divalent thiol, or polythiophenol having two or more thiophenolic mercapto groups.

Examples of the polymer having a specific partial structure represented by Formula (1) include a polymer having a repeating unit represented by Formula (3-1), a polymer having a repeating unit represented by Formula (3-2), a polymer having a repeating unit represented by Formula (3-3), and a polymer having a repeating unit represented by Formula (3-4).

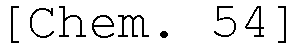

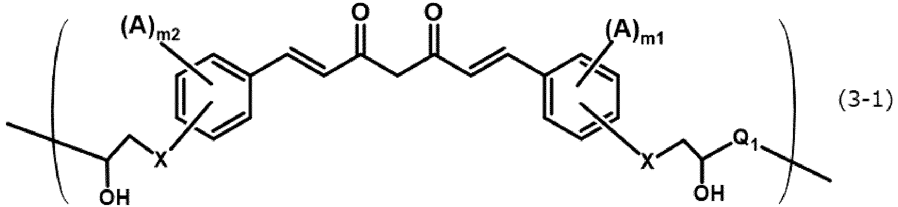

In Formula (3-1), -Q₁- represents -T₁-, -CH₂O-T₁-O-CH₂-, -CH₂OCH₂-T₁-CH₂OCH₂-, or -CH₂OC(=O)-T₁-C(=O)OCH₂-. Each T₁ independently represents a divalent acyclic group or a divalent group having a cyclic structure. -X- and A are identical to -X- and A in Formula (1). m₁ satisfies 0 ≤ m₁ ≤ 4, and m₂ satisfies 0 ≤ m₂ ≤ 4.

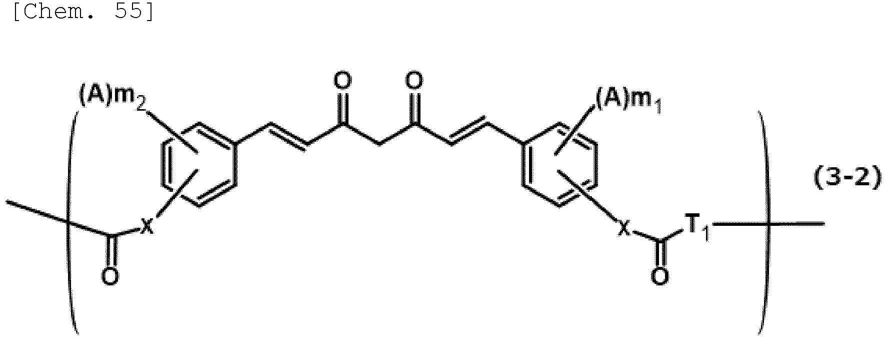

In Formula (3-2), T₁ represents a divalent acyclic group or a divalent group having a cyclic structure. -X- and A are identical to -X- and A in Formula (1). m₁ satisfies 0 ≤ m₁ ≤ 4, and m₂ satisfies 0 ≤ m₂ ≤ 4.

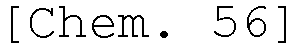

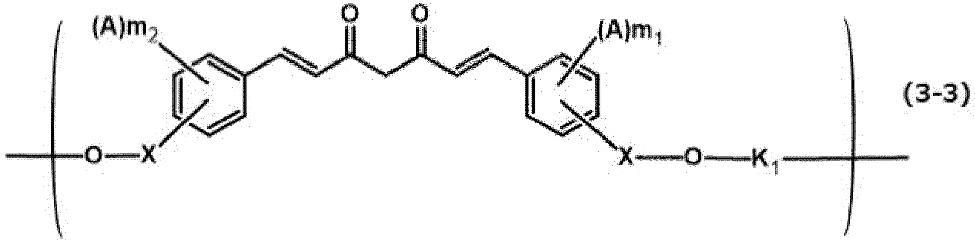

In Formula (3-3), -K₁- represents -CH₂-T₁-CH₂- or -C₆H₄-T₁-C₆H₄-. Each T₁ independently represents a divalent acyclic group or a divalent group having a cyclic structure. -X- and A are identical to -X- and A in Formula (1). m₁ satisfies 0 ≤ m₁ ≤ 4, and m₂ satisfies 0 ≤ m₂ ≤ 4.

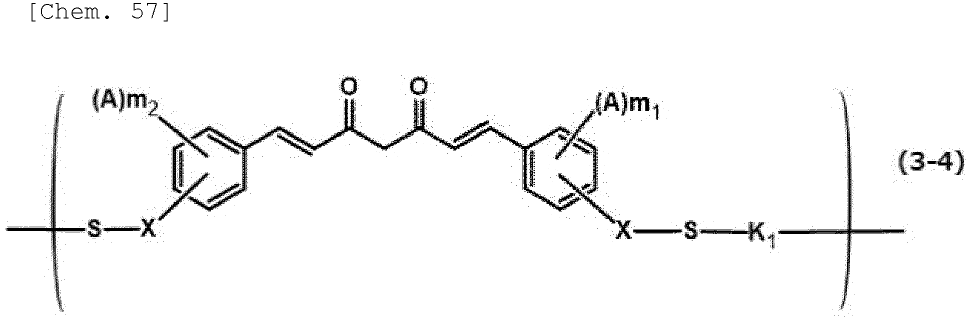

In Formula (3-4), -K₁- represents -CH₂-T₁-CH₂- or -C₆H₄-T₁-C₆H₄-. Each T₁ independently represents a divalent acyclic group or a divalent group having a cyclic structure. -X- and A are identical to -X- and A in Formula (1). m₁ satisfies 0 ≤ m₁ ≤ 4, and m₂ satisfies 0 ≤ m₂ ≤ 4.

In Formula (3-1), -Q₁- represents -T₁-, -CH₂O-T₁-O-CH₂-, -CH₂OCH₂-T₁-CH₂OCH₂-, or -CH₂O_{C}(=O)-T₁-C(=O)OCH₂-, where each T₁ independently represents a divalent acyclic group or a divalent group having a cyclic structure as described above.

The divalent acyclic group in T₁ of Formula (3-1) refers to a divalent group containing no cyclic structure, and examples thereof include a divalent acyclic hydrocarbon group having 1 to 20 carbon atoms which may be interrupted by an oxygen atom or a sulfur atom.

Examples of the divalent acyclic hydrocarbon group having 1 to 20 carbon atoms include an alkylene group having 1 to 10 carbon atoms (preferably, an alkylene group having 1 to 6 carbon atoms), -CH₂CH₂-(OCH₂CH₂)ₙ-(n represents an integer of 1 to 9), and -CH(CH₃)CH₂-(OCH(CH₃)CH₂)ₙ- (n represents an integer of 1 to 5).

The alkylene group having 1 to 20 carbon atoms refers to a divalent group derived by further removing one hydrogen atom from the alkyl group. The alkylene group may be linear or branched.

The divalent group having a cyclic structure in T1 of Formula (3-1) refers to, for example, a divalent organic group having a cyclic structure which may have a substituent, and examples thereof include a divalent organic group having an aromatic hydrocarbon ring or aliphatic hydrocarbon ring which may have a substituent, and a divalent organic group having a heterocyclic ring (heterocycle) containing a hetero atom such as oxygen, nitrogen, or sulfur other than carbon as a constituent element of the ring.

Specific examples of the aromatic hydrocarbon ring of T₁ in Formula (3-1) include benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, and dibenzo[a,j]anthracene.

Specific examples of the heterocyclic ring of T₁ in Formula (3-1) include furan, thiophene, pyrrole, imidazole, pyran, pyridine, pyrimidine, pyrazine, pyrrolidine, piperidine, piperazine, morpholine, quinuclidine, indole, purine, thymine, quinoline, isoquinoline, chromene, thianthrene, phenothiazine, phenoxazine, xanthene, acridine, phenazine, carbazole, hydantoin, uracil, barbituric acid, triazine, and cyanuric acid. The heterocyclic ring may be triazinetrione, dioxoimidazoline, or diazinetrione.

Examples of the substituent in the cyclic structure which may have a substituent in T₁ of Formula (3-1) include a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, and an aralkyl group having 7 to 13 carbon atoms.

Examples of a preferable embodiment of the divalent organic group having an aromatic hydrocarbon ring or aliphatic hydrocarbon ring in T₁ of Formula (3-1) include a divalent organic group represented by Formula (3-5-1), a divalent organic group represented by Formula (3-5-2), a divalent organic group represented by Formula (3-5-3), and a divalent organic group represented by Formula (3-5-4).

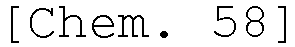

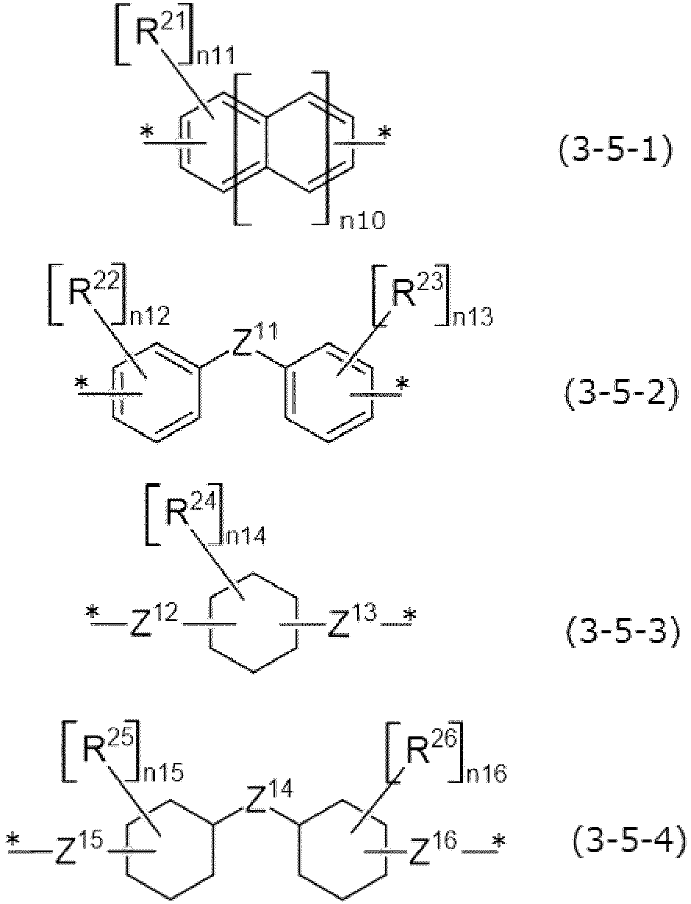

(In Formulae (3-5-1) to (3-5-4), R²¹ to R²⁶ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms. * represents a bond.

In Formula (3-5-1), n10 represents 0 or 1. When n10 is 0, n11 represents an integer of 0 to 4. When n10 is 1, n11 represents an integer of 0 to 6. When two or more R²¹s are present, the two or more R²¹s may be identical to or different from each other.

In Formula (3-5-2), Z¹¹ represents a single bond, an oxygen atom, a sulfur atom, a carbonyl group, a sulfonyl group, or an alkylene group having 1 to 6 carbon atoms. n12 and n13 each independently represent an integer of 0 to 4. When two or more R²²s are present, the two or more R²²s may be identical to or different from each other. When two or more R²³s are present, the two or more R²³s may be identical to or different from each other.

In Formula (3-5-3), Z¹² and Z¹³ each independently represent a single bond or a linear or branched alkylene group having 1 to 6 carbon atoms. n14 represents an integer of 0 to 4. When two or more R²⁴s are present, the two or more R²⁴s may be identical to or different from each other.

In Formula (3-5-4), Z¹⁴ represents a single bond, an oxygen atom, a sulfur atom, a carbonyl group, a sulfonyl group, or an alkylene group having 1 to 6 carbon atoms. Z¹⁵ and Z¹⁶ each independently represent a single bond or a linear or branched alkylene group having 1 to 6 carbon atoms. n15 and n16 each independently represent an integer of 0 to 4. When two or more R²⁵s are present, the two or more R²⁵s may be identical to or different from each other. When two or more R²⁶s are present, the two or more R²⁶s may be identical to or different from each other.)

The preferable embodiment of the divalent organic group having a heterocyclic ring in T₁ of Formula (3-1) include a divalent organic group represented by Formula (3-6).

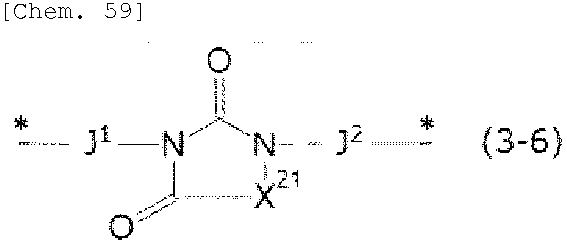

In Formula (3-6), X²¹ represents a divalent group represented by any one of Formulae (3-6-1) to (3-6-3). J¹ and J² each independently represent a single bond or a divalent group represented by Formula (3-6-5).)

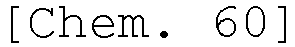

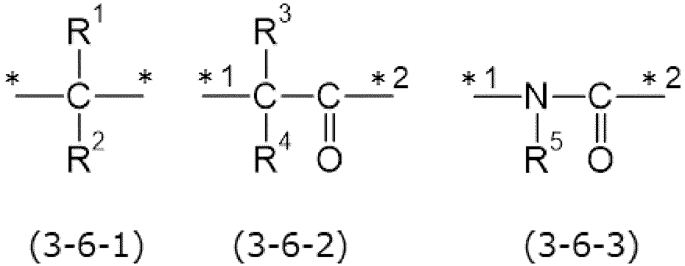

(In Formulae (3-6-1) to (3-6-3), R¹ to R⁵ each independently represent a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, where the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms. R¹ and R² may be bonded to each other to form a ring having 3 to 6 carbon atoms. R³ and R⁴ may be bonded to each other to form a ring having 3 to 6 carbon atoms.
* represents a bond. *1 represents a bond bonded to a carbon atom in the formula (3-6). *2 represents a bond bonded to a nitrogen atom in the formula (3-6).)

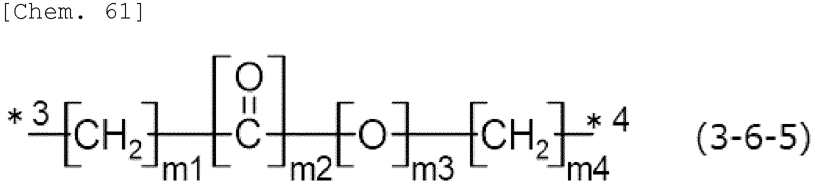

(In Formula (3-6-5), m1 is an integer of 0 to 4, m2 is 0 or 1, m3 is 0 or 1, and m4 is an integer of 0 to 2. Here, in a case where m3 is 1, m1 and m2 are not simultaneously 0. *3 represents a bond bonded to a nitrogen atom in Formula (3-6). *4 represents a bond.)

T₁ in Formula (3-2) is also the same as T₁ in Formula (3-1).

T₁ in Formula (3-3) is also the same as T₁ in Formula (3-1).

T₁ in Formula (3-4) is also the same as T₁ in Formula (3-1).

### <<Method for Producing Polymer Having Specific Partial Structure>>>

### <<<Method for Producing Polymer Having Repeating Unit Represented by Formula (3-1)>>>

Among the polymers, each having a specific partial structure, for example, the polymer represented by Formula (3-1) can be obtained by reacting a compound represented by any one of Formulae (A-1) to (A-4) and a bifunctional epoxy compound, but the reaction method is not particularly limited, and the compound can be produced using a known method. For example, the production can be carried out by a method described in Examples described later.

The compounds represented by Formulae (A-1) to (A-4) are as described in the above section of <Compound Having Specific Partial Structure>.

Examples of the bifunctional epoxy compound include an epoxy compound represented by Formula (F).

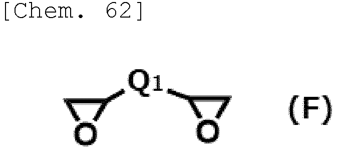

In Formula (F), -Q₁- represents -T₁-, -CH₂O-T₁-O-CH₂-, - CH₂OCH₂-T₁-CH₂OCH₂-, or -CH₂OC(=O)-T₁-C(=O)OCH₂- as in Formula (3-1).

Examples of the epoxy compound represented by Formula (F) include epoxy compounds represented by the following structural formulae.

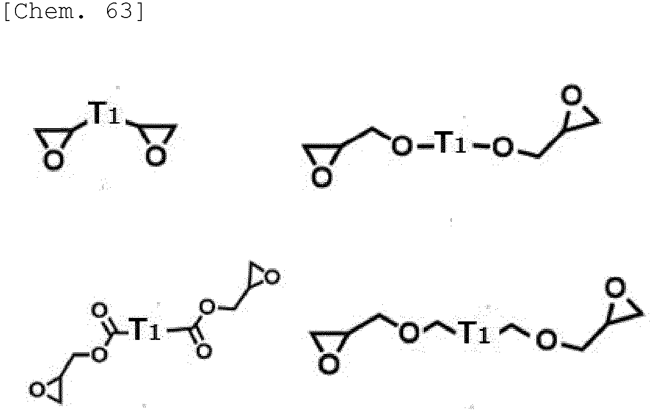

In the epoxy compounds represented by the structural formulae, each T₁ is as described above.

Specific examples of the bifunctional epoxy compound include a compound represented as follows.

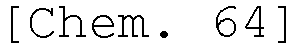

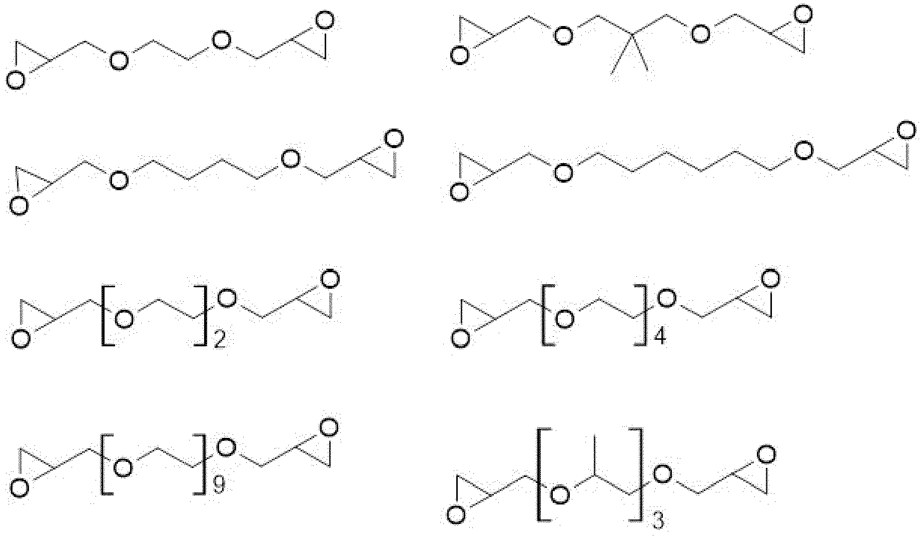

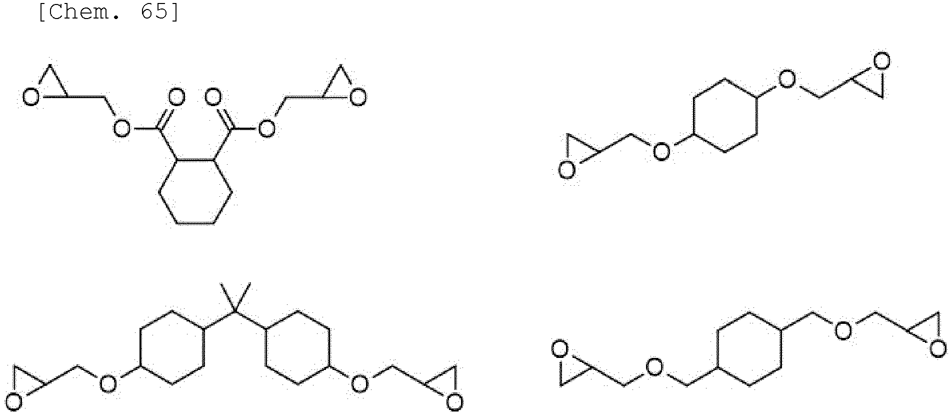

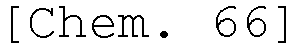

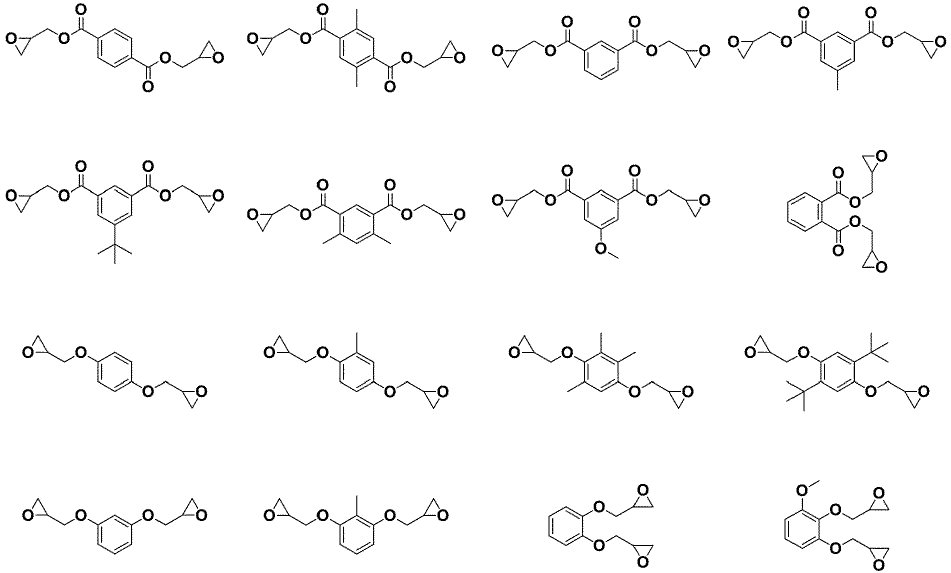

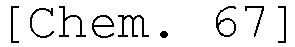

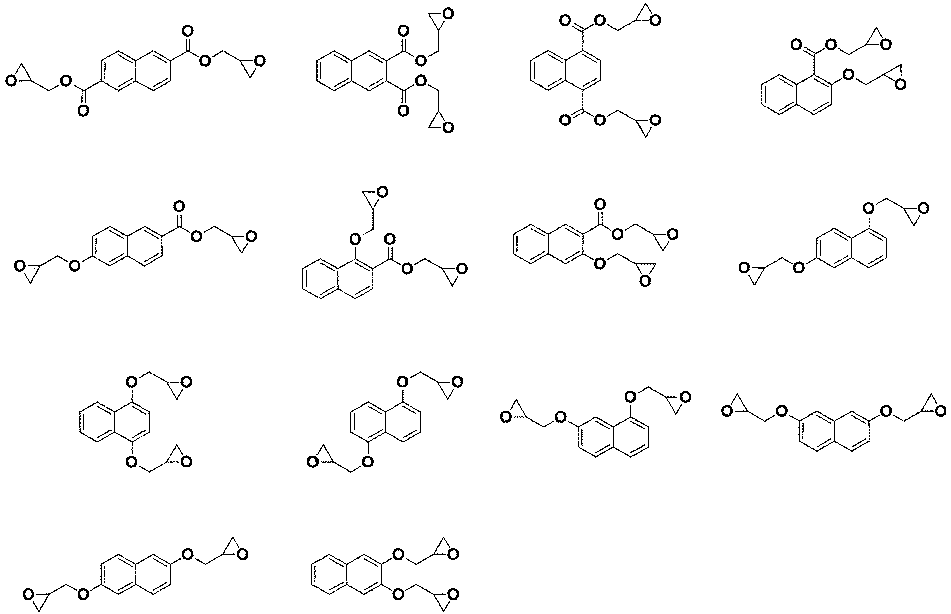

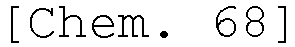

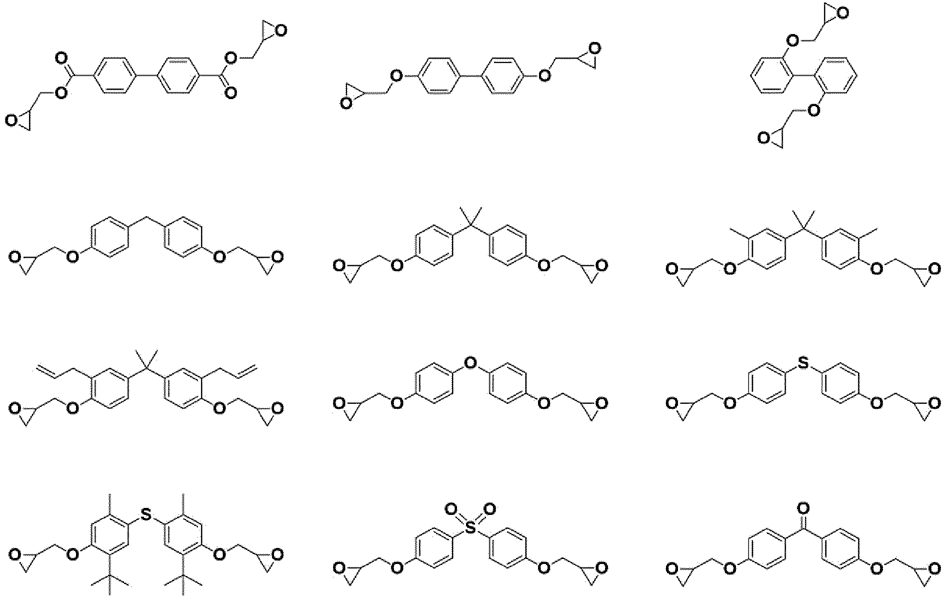

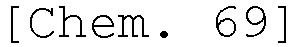

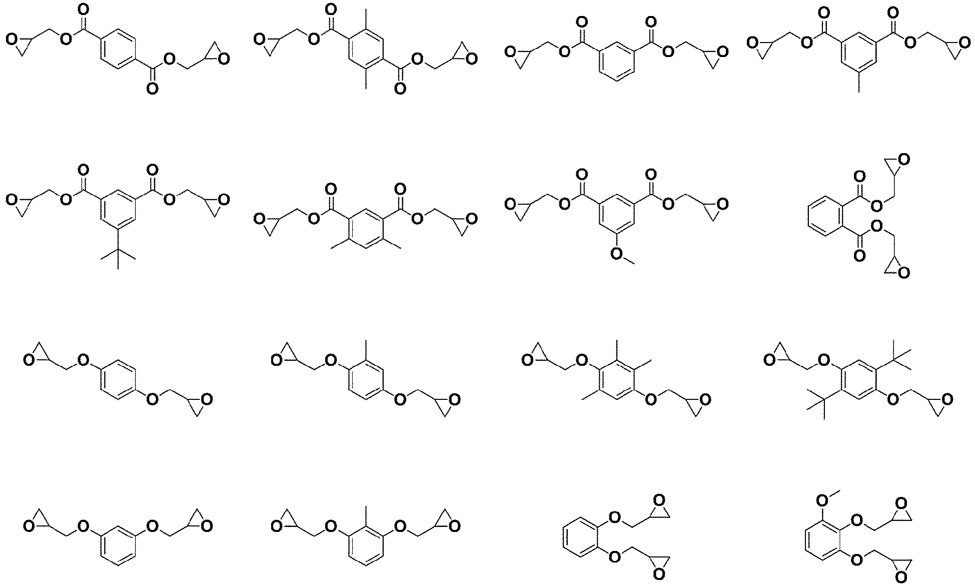

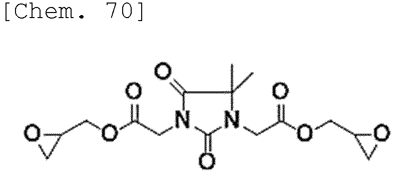

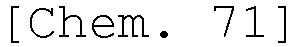

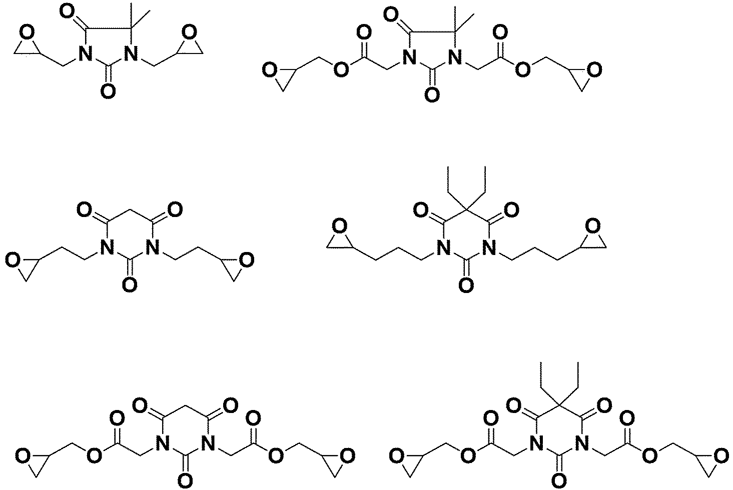

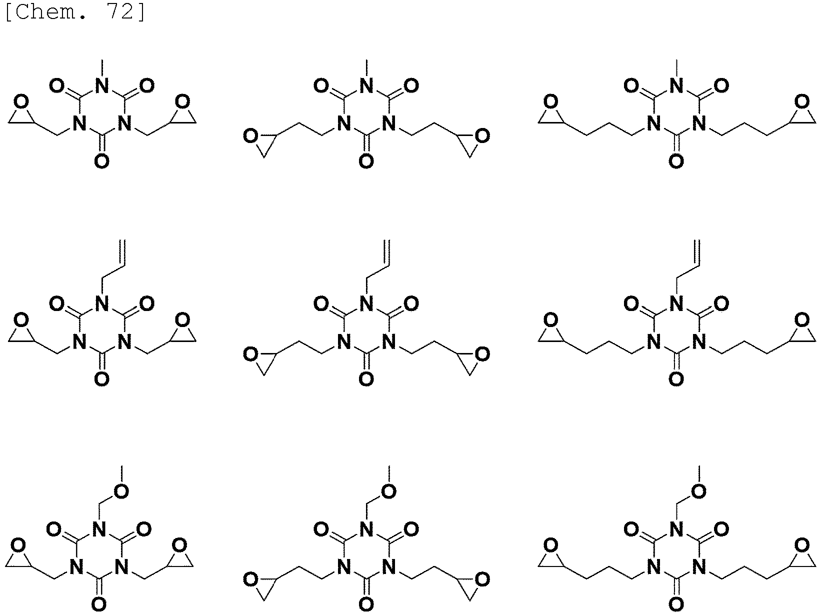

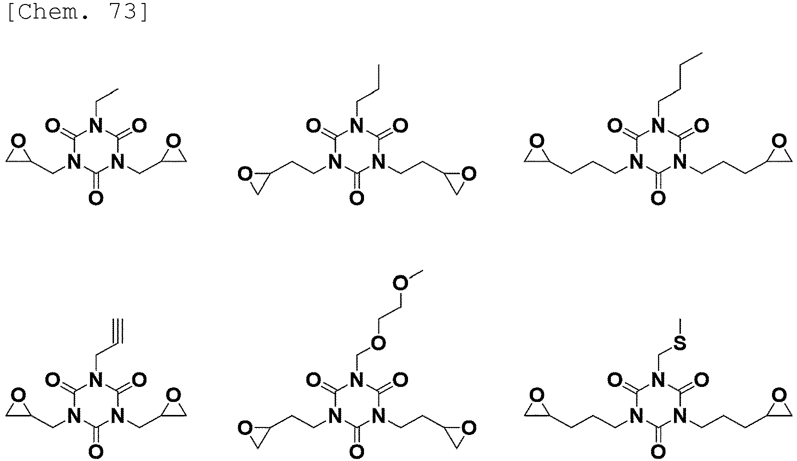

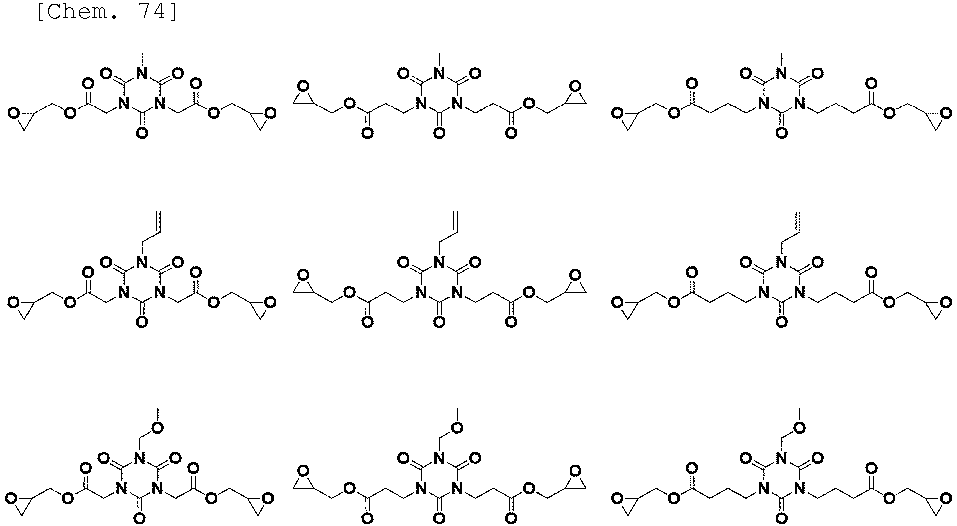

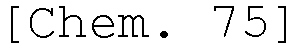

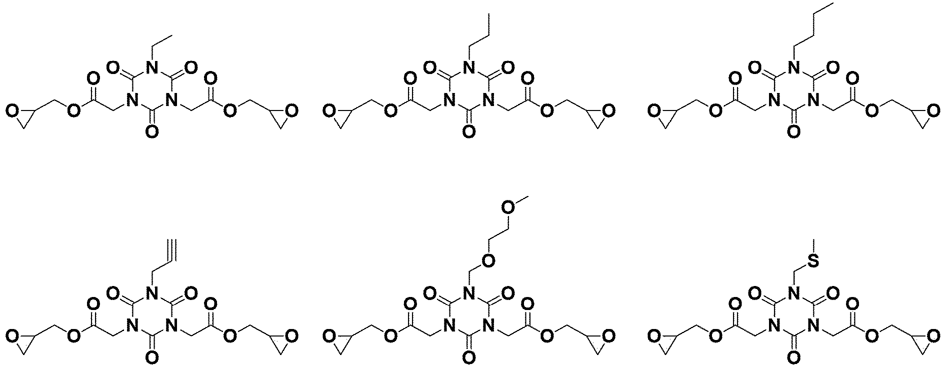

### <<<Method for Producing Polymer Having Repeating Unit Represented by Formula (3-2)>>>

Among the polymers, each having a specific partial structure, for example, the polymer having a repeating unit represented by Formula (3-2) can be obtained by reacting a compound represented by any one of Formulae (A-1) to (A-3) and a bifunctional carboxylic acid, but the reaction method is not particularly limited, and the compound can be produced using a known method.

Examples of the bifunctional carboxylic acid include a carboxylic acid represented by Formula (G).

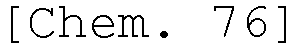

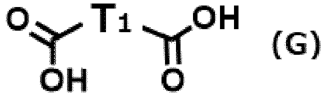

In Formula (G), T₁ is the same as Formula (3-2) or Formula (F).

When at least any one of the compound having a partial structure represented by Formula (1) or the polymer having a structure represented by Formula (1) is contained in the resist underlayer film-forming composition, the resist underlayer film formed using the resist underlayer film-forming composition can exhibit not only excellent resistance to a resist solvent or a resist developer which is an alkaline aqueous solution but also excellent removability (solubility) in a wet etching chemical liquid.

More preferably, when at least any one of the compound represented by Formula (2-1), the compound represented by Formula (2-2), the compound represented by Formula (2-3), the compound represented by Formula (2-4), the polymer having a repeating unit represented by Formula (3-1), the polymer having a repeating unit represented by Formula (3-2), the polymer having a repeating unit represented by Formula (3-3), or the polymer having a repeating unit represented by Formula (3-4) is contained in the resist underlayer film-forming composition, the resist underlayer film formed using the resist underlayer film-forming composition can exhibit not only excellent resistance to a resist solvent or a resist developer which is an alkaline aqueous solution but also excellent removability (solubility) in a wet etching chemical liquid.

The resist underlayer film-forming composition of the present invention is a composition for forming a resist underlayer film that can be removed by a chemical liquid for wet etching a copper substrate or the like described below. For this purpose, the resist underlayer film-forming composition of the present invention can also be used as a composition for application on a substrate containing copper on a surface thereof.

### <Solvent>

As a solvent for the resist underlayer film-forming composition according to the present invention, any solvent can be used without particular limitation as long as it can dissolve the compound or polymer having a specific partial structure, or the compound represented by Formula (2-1), the compound represented by Formula (2-2), the compound represented by Formula (2-3), the compound represented by Formula (2-4), the polymer having a repeating unit represented by Formula (3-1), the polymer having a repeating unit represented by Formula (3-2), the polymer having a repeating unit represented by Formula (3-3), or the polymer having a repeating unit represented by Formula (3-4) (hereinbelow, these are collectively referred to as a "compound or polymer having a specific structure), and other components described later. In particular, since the resist underlayer film-forming composition according to the present invention is used in a uniform solution state, it is recommended to use a solvent generally used in a lithography process in combination in consideration of its coating performance.

Examples of the solvent include methyl cellosolve acetate, ethyl cellosolve acetate, propylene glycol, propylene glycol monomethyl ether, propylene glycol monoethyl ether, methyl isobutyl carbinol, propylene glycol monobutyl ether, propylene glycol monomethyl ether acetate, propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether, ethylene glycol monoethyl ether, ethylene glycol monopropyl ether, ethylene glycol monobutyl ether, ethylene glycol monomethyl ether acetate, ethylene glycol monoethyl ether acetate, ethylene glycol monopropyl ether acetate, ethylene glycol monobutyl ether acetate, diethylene glycol dimethyl ether, diethylene glycol diethyl ether, diethylene glycol dipropyl ether, diethylene glycol dibutyl ether propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, methyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutylpropionate, 3-methyl-3-methoxybutylbutyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methylpyrrolidone, 4-methyl-2-pentanol, and γ-butyrolactone. These solvents can be used alone or in combination of two or more thereof.

Propylene glycol monomethyl ether, propylene glycol monomethyl ether acetate, ethyl lactate, butyl lactate, cyclohexanone, and the like are preferable. In particular, propylene glycol monomethyl ether and propylene glycol monomethyl ether acetate are preferable.

The resist underlayer film-forming composition of the present invention can further contain at least one selected from the group consisting of a crosslinking agent, an acid, and an acid generator, and other components, in addition to the compound or polymer having a specific structure, and the solvent.

### <Crosslinking Agent>

The resist underlayer film-forming composition of the present invention can contain a crosslinking agent component. Examples of the crosslinking agent include a melamine-based crosslinking agent, a substituted urea-based crosslinking agent, and a polymer-based crosslinking agent thereof. Preferably, the crosslinking agent is a crosslinking agent having at least two crosslinking forming substituents, and is a compound such as methoxymethylated glycoluril (for example, tetramethoxymethylglycoluril), butoxymethylated glycoluril, methoxymethylated melamine, butoxymethylated melamine, methoxymethylated benzoguanamine, butoxymethylated benzoguanamine, methoxymethylated urea, butoxymethylated urea, or methoxymethylated thiourea. In addition, condensates of these compounds can also be used.

In addition, as the crosslinking agent, a compound containing a crosslinking substituent having an aromatic ring (for example, a benzene ring or a naphthalene ring) in the molecule can be used.

Examples of the compound include a compound having a partial structure of the following Formula (6) and a polymer or oligomer having a repeating unit of the following Formula (7).

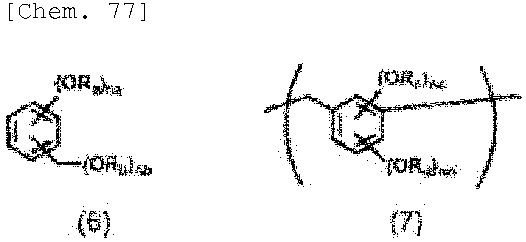

Rₐ, R_{b}, R_{c}, and R_{d} are each a hydrogen atom or an alkyl group having 1 to 10 carbon atoms, and na, nb, nc, and nd each represent an integer of 0 to 3. As the alkyl group, the examples described above can be used.

The compounds, polymers, and oligomers of Formula (6) and Formula (7) are exemplified below.

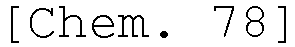

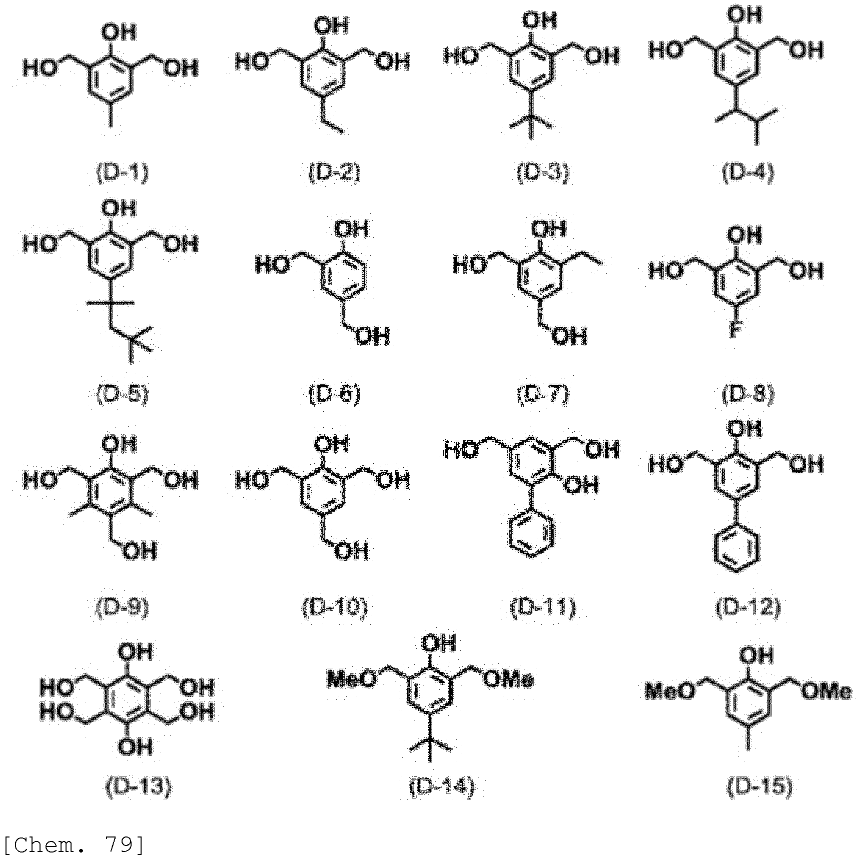

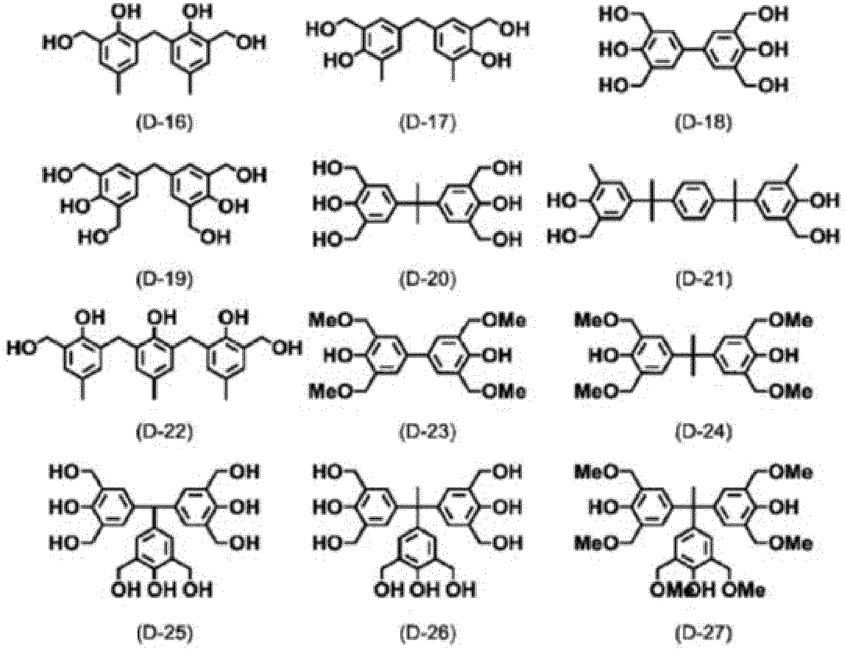

The compound can be obtained from products of ASAHI YUKIZAI CORPORATION and Honshu Chemical Industry Co., Ltd. For example, among the crosslinking agents, the compound of Formula (D-24) can be obtained from trade name TM-BIP-A manufactured by ASAHI YUKIZAI CORPORATION.

The amount of the crosslinking agent added varies depending on a coating solvent to be used, a base substrate to be used, a required solution viscosity, a required film shape, and the like, and is 0.001 to 80 mass%, preferably 0.01 to 50 mass%, and more preferably 0.05 to 40 mass%, with respect to the total solid content. Although these crosslinking agents may cause a crosslinking reaction by self-condensation, they may cause a crosslinking reaction with a crosslinkable substituent in the compound or polymer having a specific structure of the present invention when it is present.

### <Acid and/or Acid Generator>

The resist underlayer film-forming composition of the present invention can contain an acid and/or an acid generator.

Examples of the acid include p-toluenesulfonic acid, trifluoromethanesulfonic acid, pyridinium trifluoromethanesulfonic acid, pyridinium p-toluenesulfonic acid, pyridinium phenolsulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, citric acid, benzoic acid, hydroxybenzoic acid, and naphthalenecarboxylic acid.

The acids can be used singly or in combination two or more kinds thereof. A blending amount is usually 0.0001 to 20 mass%, preferably 0.0005 to 10 mass%, and more preferably 0.01 to 3 mass%, with respect to the total solid content.

Examples of the acid generator include a thermal acid generator and a photoacid generator.

Examples of the thermal acid generator include pyridinium trifluoromethanesulfonic acid, pyridinium p-toluenesulfonic acid, pyridinium phenol sulfonic acid, 2,4,4,6-tetrabromo cyclohexadienone, benzoin tosylate, 2-nitrobenzyl tosylate, and other organic sulfonic acid alkyl esters.

The photoacid generator generates an acid during exposure of the resist. Therefore, the acidity of the underlayer film can be adjusted. The photoacid generator is one method for adjusting the acidity of the underlayer film to the acidity of the upper layer resist. In addition, the pattern shape of the resist formed on the upper layer can be adjusted by adjusting the acidity of the underlayer film.

Examples of the photoacid generator contained in the resist underlayer film-forming composition of the present invention include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoro-n-butanesulfonate, diphenyliodonium perfluoro-n-octanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoron-butanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, N-(trifluoromethanesulfonyloxy)naphthalimide, and other sulfonimide compounds.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, methylsulfonyl-p-toluenesulfonyl diazomethane, and other disulfonyl diazomethane compounds.

The acid generators can be used singly or in combination two or more kinds thereof.

In a case where the acid generator is used, a ratio thereof is usually 0.0001 to 20 mass%, preferably 0.0005 to 10 mass%, and more preferably 0.01 to 3 mass%, with respect to 100 parts by mass of the solid content of the resist underlayer film-forming composition.

### <Other Components>

In the resist underlayer film-forming composition of the present invention, a surfactant can be blended in order to further improve the coatability for surface unevenness without generating pinholes, striations, and the like. Examples of the surfactant include nonionic surfactants such as polyoxyethylene alkyl ethers such as polyoxyethylene lauryl ether, polyoxyethylene stearyl ether, polyoxyethylene cetyl ether, and polyoxyethylene oleyl ether, polyoxyethylene alkylallyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (manufactured by Tochem Products Co. Ltd., trade name), Megafac F171, F173, R-30, R-30N, R-40, R-40N, and R-40LM (manufactured by DIC Corporation, trade name), Fluorad FC430 and FC431 (manufactured by Sumitomo 3M Limited, trade name), and AsahiGuard AG710 and Surflon S-382, SC101, SC102, SC103, SC104, SC105, and SC106 (manufactured by AGC Inc., trade name), and organosiloxane polymer KP341 (manufactured by Shin-Etsu Chemical Co., Ltd.).

A blending amount of these surfactants is usually 2.0 mass% or less, and preferably 1.0 mass% or less, with respect to the total solid content of a resist underlayer film material. These surfactants can be used alone or in combination of two or more thereof. In a case where the surfactant is used, a ratio thereof is 0.0001 to 5 parts by mass, 0.001 to 1 part by mass, or 0.01 to 0.5 parts by mass, with respect to 100 parts by mass of the solid content of the resist underlayer film-forming composition.

A light absorber, a rheology modifier, an adhesion assistant, or the like can be added to the resist underlayer film-forming composition of the present invention. The rheology modifier is effective in improving fluidity of the composition for forming an underlayer film. The adhesion assistant is effective for improving adhesion between a semiconductor substrate or a resist and an underlayer film.

As the light absorber, commercially available light absorbers described in "Technique and Market of Industrial Pigments" (CMC Publishing Co., Ltd.) or "Dye Handbook" (edited by The Society of Synthetic Organic Chemistry, Japan), such as C.I. Disperse Yellow 1, 3, 4, 5, 7, 8, 13, 23, 31, 49, 50, 51, 54, 60, 64, 66, 68, 79, 82, 88, 90, 93, 102, 114, and 124; C.I. Disperse Orange 1, 5, 13, 25, 29, 30, 31, 44, 57, 72, and 73; C.I. Disperse Red 1, 5, 7, 13, 17, 19, 43, 50, 54, 58, 65, 72, 73, 88, 117, 137, 143, 199, and 210; C.I. Disperse Violet 43; C.I. Disperse Blue 96; C.I. Fluorescent Brightening Agent 112, 135, and 163; C.I. Solvent Orange 2 and 45; C.I. Solvent Red 1, 3, 8, 23, 24, 25, 27, and 49; C.I. Pigment Green 10; and C.I. Pigment Brown 2, can be suitably used. The light absorber is usually blended in a ratio of 10 mass% or less, and preferably 5 mass% or less, with respect to the total solid content of the resist underlayer film-forming composition.

The rheology modifier is added mainly to improve fluidity of the resist underlayer film-forming composition, and in particular, to improve thickness uniformity of the resist underlayer film or to enhance filling properties of the resist underlayer film-forming composition into holes in a baking step.

Specific examples thereof include phthalic acid derivatives such as dimethyl phthalate, diethyl phthalate, diisobutyl phthalate, dihexyl phthalate, and butylisodecyl phthalate; adipic acid derivatives such as di-n-butyl adipate, diisobutyl adipate, diisooctyl adipate, and octyldecyl adipate; maleic acid derivatives such as di-n-butyl maleate, diethyl maleate, and dinonyl maleate; oleic acid derivatives such as methyl oleate, butyl oleate, and tetrahydrofurfuryl oleate; and stearic acid derivatives such as n-butyl stearate and glyceryl stearate.

These rheology modifiers are usually blended in a ratio of less than 30 mass% with respect to the total solid content of the resist underlayer film-forming composition.

The adhesion assistant is mainly added to improve adhesion of the resist underlayer film-forming composition to a substrate or a resist, and in particular, to prevent peeling of the resist in development.

Specific examples thereof include chlorosilanes such as trimethylchlorosilane, dimethylmethylolchlorosilane, methyldiphenylchlorosilane, and chloromethyldimethylchlorosilane; alkoxysilanes such as trimethylmethoxysilane, dimethyldiethoxysilane, methyldimethoxysilane, dimethylmethylolethoxysilane, diphenyldimethoxysilane, and phenyltriethoxylsilane; silazanes such as hexamethyldisilazane, N,N'-bis(trimethylsilyl)urea, dimethyltrimethylsilylamine, and trimethylsilylimidazole; silanes such as methyloltrichlorosilane, γ-chloropropyltrimethoxysilane, γ-aminopropyltriethoxysilane, and γ-glycidoxypropyltrimethoxysilane; heterocyclic compounds such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine; and urea such as 1,1-dimethyl urea or 1,3-dimethyl urea or thiourea compounds.

These adhesion assistants are usually blended in a ratio of less than 5 mass%, and preferably less than 2 mass%, with respect to the total solid content of the resist underlayer film-forming composition.

A solid content of the resist underlayer film-forming composition according to the present invention is usually 0.1 to 70 mass%, 0.1 to 60 mass%, 0.1 to 50 mass%, 0.1 to 40 mass%, 0.1 to 30 mass%, 0.1 to 20 mass%, 0.1 to 10 mass%, 0.1 to 5 mass%, 0.1 to 3 mass%, or 0.1 to 2 mass%. The solid content is a content ratio of all components excluding the solvent from the resist underlayer film-forming composition. A ratio of at least any one of the compound having a partial structure represented by Formula (1) or the polymer having a partial structure represented by Formula (1) in the solid content is preferably in the order of 1 to 100 mass%, 1 to 99.9 mass%, 50 to 99.9 mass%, 50 to 95 mass%, and 50 to 90 mass%.

One of the indices for evaluating whether the resist underlayer film-forming composition is in a uniform solution state is to observe permeability through a specific microfilter, and the resist underlayer film-forming composition according to the present invention permeates through a microfilter having a pore size of 0.1 µm and exhibits a uniform solution state.

Examples of a material of the microfilter include fluorine-based resins such as polytetrafluoroethylene (PTFE) and a tetrafluoroethylene-perfluoroalkyl vinyl ether copolymer (PFA), polyethylene (PE), ultra high molecular weight polyethylene (UPE), polypropylene (PP), polysulfone (PSF), polyether sulfone (PES), and nylon, and a microfilter formed of polytetrafluoroethylene (PTFE) is preferable.

### (Resist Underlayer Film and Method For Manufacturing Semiconductor Device)

Hereinafter, a resist underlayer film and a method for manufacturing a semiconductor device using the resist underlayer film-forming composition according to the present invention will be described.

First, a substrate used for manufacturing a semiconductor device will be described.

### <Substrate>

In the present invention, a substrate used for manufacturing a semiconductor device includes, for example, a silicon wafer substrate, a silicon/silicon dioxide coating substrate, a silicon nitride substrate, a glass substrate, an ITO substrate, a polyimide substrate, a low dielectric constant material (low-k material) coating substrate, and the like.

Note that, in recent years, in the three-dimensional mounting field of semiconductor manufacturing processes, the FOWLP process has started to be applied for the purpose of high-speed responsiveness and power saving by shortening the wiring length between semiconductor chips. In a redistribution layer (RDL) process of creating a wiring between semiconductor chips, copper (Cu) is used as a wiring member, and it is necessary to apply an anti-reflective film (resist underlayer film-forming composition) as the copper wiring becomes finer. The resist underlayer film-forming composition according to the present invention can also be suitably applied onto a substrate containing copper and copper oxide on a surface thereof.

The resist underlayer film-forming composition of the present invention is applied onto a substrate (for example, a substrate containing copper on a surface thereof) used for manufacturing the semiconductor device described above by an appropriate coating method such as a spinner or a coater, and then baked to form a resist underlayer film.

The baking conditions are appropriately selected from a baking temperature of 80°C to 400°C and a baking time of 0.3 to 60 minutes. Preferably, the baking temperature is 150°C to 350°C and the baking time is 0.5 to 2 minutes. Here, a thickness of the underlayer film to be formed is, for example, 10 to 1,000 nm, 20 to 500 nm, 30 to 400 nm, or 50 to 300 nm.

In addition, an inorganic resist underlayer film (hard mask) can be formed on the organic resist underlayer film according to the present invention. For example, in addition to the method for forming a silicon-containing resist underlayer film (inorganic resist underlayer film) forming composition described in WO 2009/104552 A1 by spin coating, a Si-based inorganic material film can be formed by a CVD method or the like.

Next, a resist film, for example, a photoresist layer is formed on the resist underlayer film. The photoresist layer can be formed by a well-known method of removing a solvent from a coating film including the resist underlayer film-forming composition, that is, by applying a photoresist composition solution onto the underlayer film and baking the photoresist composition. A thickness of the photoresist is, for example, 50 to 10,000 nm or 100 to 2,000 nm.

The photoresist formed on the resist underlayer film is not particularly limited as long as it is sensitive to light used for exposure. Both a negative photoresist and a positive photoresist can be used. Examples of the photoresist include a positive photoresist formed of a novolac resin and 1,2-naphthoquinonediazide sulfonic acid ester, a chemically amplified photoresist formed of a binder having a group degradable by an acid to increase an alkali dissolution rate and a photoacid generator, a chemically amplified photoresist formed of a low molecular weight compound degradable by an acid to increase an alkali dissolution rate of the photoresist, an alkali-soluble binder, and a photoacid generator, and a chemically amplified photoresist formed of a binder having a group degradable by an acid to increase an alkali dissolution rate, a low molecular weight compound degradable by an acid to increase an alkali dissolution rate of the photoresist, and a photoacid generator. Examples thereof include APEX-E (trade name) manufactured by Shipley Company L.L.C, PAR710 (trade name) manufactured by Sumitomo Chemical Co., Ltd., and SEPR430 (trade name) manufactured by Shin-Etsu Chemical Co., Ltd. Furthermore, examples thereof include fluorine-containing atomic polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Next, a resist pattern is formed by irradiation with light or an electron beam and development. First, exposure is performed through a predetermined mask. For the exposure, a near ultraviolet ray, a far ultraviolet ray, an extreme ultraviolet ray (for example, EUV (wavelength 13.5 nm)), or the like is used. Specifically, an i-ray (wavelength: 365 nm), a KrF excimer laser (wavelength: 248 nm), an ArF excimer laser (wavelength: 193 nm), an F2 excimer laser (wavelength: 157 nm), and the like can be used. Among them, an i-ray (wavelength: 365 nm) is preferable. After the exposure, post exposure bake can be performed, if necessary. After the exposure, heating is performed under conditions appropriately selected from a heating temperature of 70°C to 150°C and a heating time of 0.3 to 10 minutes.

In addition, in the present invention, a resist for electron beam lithography can be used instead of a photoresist. As the electron beam resist, both a negative type and a positive type can be used. Examples of the photoresist include a chemically amplified resist formed of a binder having a group degradable by an acid generator and an acid to change an alkali dissolution rate, a chemically amplified resist formed of a low molecular weight compound degradable by an alkali-soluble binder, an acid generator, and an acid to change an alkali dissolution rate of the resist, a chemically amplified resist formed of a binder having a group degradable by an acid generator and an acid to change an alkali dissolution rate and a low molecular weight compound degradable by an acid to change an alkali dissolution rate of the resist, a non-chemically amplified resist formed of a binder having a group degradable by an electron beam to change an alkali dissolution rate, and a non-chemically amplified resist formed of a binder having a portion cut by an electron beam to change an alkali dissolution rate. Even in a case of using these electron beam resists, a resist pattern can be formed similarly to a case of using a photoresist obtained using an irradiation source as an electron beam.

Next, development is performed with a developer. Therefore, for example, in a case where a positive photoresist is used, the photoresist of the exposed portion is removed, and a photoresist pattern is formed.

Examples of the developer include alkaline aqueous solutions such as aqueous solutions of alkali metal hydroxides such as potassium hydroxide and sodium hydroxide; aqueous solutions of quaternary ammonium hydroxides such as tetramethylammonium hydroxide, tetraethylammonium hydroxide, and choline; and amine aqueous solutions such as ethanolamine, propylamine, and ethylenediamine. Furthermore, a surfactant or the like can be added to the developer. The conditions for the development are appropriately selected from a temperature of 5°C to 50°C and a time of 10 to 600 seconds.

In the present invention, after an organic underlayer film (underlayer) is formed on a substrate, an inorganic underlayer film (intermediate layer) is formed thereon, and a photoresist (upper layer) can be further coated thereon. Therefore, even in a case where a pattern width of the photoresist becomes narrower and the photoresist is thinly coated to prevent the pattern from being collapsed, processing of the substrate can be performed by selecting an appropriate etching gas. For example, it is possible to perform processing on the resist underlayer film using, as an etching gas, a fluorine-based gas having a sufficiently high etching rate with respect to a photoresist, to perform processing on the substrate using, as an etching gas, a fluorine-based gas having a sufficiently high etching rate with respect to an inorganic underlayer film, and to perform processing on the substrate using, as an etching gas, an oxygen-based gas having a sufficiently high etching rate with respect to an organic underlayer film.

Then, the inorganic underlayer film is removed using the photoresist pattern formed as described above as a protective film, and then the organic underlayer film is removed using the film including the patterned photoresist and the inorganic underlayer film as a protective film. Finally, the semiconductor substrate is processed using the patterned inorganic underlayer film and organic underlayer film as protective films.

First, the inorganic underlayer film of the portion from which the photoresist is removed is removed by dry etching to expose the semiconductor substrate. In the dry etching of the inorganic underlayer film, gas such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride and chlorine trifluoride, chlorine, or trichloroborane and dichloroborane can be used. For the dry etching of the inorganic underlayer film, a halogen-based gas is preferably used, and a fluorine-based gas is more preferably used. Examples of the fluorine-based gas include tetrafluoromethane (CF₄), perfluorocyclobutane (C₄F₈), perfluoropropane (C₃F₈), trifluoromethane, and difluoromethane (CH₂F₂).

Thereafter, the organic underlayer film is removed using the film including the patterned photoresist and the inorganic underlayer film as a protective film.

Since the inorganic underlayer film containing many silicon atoms is hardly removed by dry etching using an oxygen-based gas, the organic underlayer film is often removed by dry etching using an oxygen-based gas.

Finally, the semiconductor substrate is processed. The semiconductor substrate is preferably processed by dry etching using the fluorine-based gas.

Examples of the fluorine-based gas include tetrafluoromethane (CF₄), perfluorocyclobutane (C₄F₈), perfluoropropane (C₃F₈), trifluoromethane, and difluoromethane (CH₂F₂).

In addition, an organic anti-reflective film can be formed on the upper layer of the resist underlayer film before the photoresist is formed. An anti-reflective film composition to be used is not particularly limited, and can be arbitrarily selected from those conventionally used in the lithography process, and the anti-reflective film can be formed by a conventionally used method, for example, application with a spinner or a coater and baking.

The resist underlayer film formed of the resist underlayer film-forming composition may absorb light used in a lithography process depending on a wavelength of the light. In such a case, it is possible to function as an anti-reflective film having an effect of preventing reflected light from the substrate. Furthermore, the underlayer film formed using the resist underlayer film-forming composition of the present invention can also function as a hard mask. The underlayer film of the present invention can also be used as a layer for preventing an interaction between a substrate and a photoresist, a layer having a function of preventing an adverse effect on a substrate of a material used for a photoresist or a substance generated during exposure to a photoresist, a layer having a function of preventing a diffusion of substances generated from a substrate during heating and baking into an upper layer photoresist, or a barrier layer for reducing a poisoning effect of a photoresist layer by a semiconductor substrate dielectric layer.

In addition, the underlayer film formed of the resist underlayer film-forming composition is applied onto a substrate in which via holes used in a dual damascene process are formed, and can be used as a filling material capable of filling the holes without gaps. The resist underlayer film can also be used as a planarization material for planarizing the surface of a semiconductor substrate having irregularities.

On the other hand, for the purpose of simplification of a process step, reduction of substrate damage, and cost reduction, a technique by wet etching removal using a chemical liquid is also studied instead of dry etching removal. However, a resist underlayer film formed using the conventional resist underlayer film-forming composition originally needs to be a cured film having solvent resistance in order to suppress mixing with the resist at the time of resist coating. In addition, at the time of resist patterning, it is required to use a developer in order to resolve the resist, but resistance to the developer is also essential. Therefore, it is difficult for the conventional technique to make the cured film insoluble in the resist solvent or the developer and soluble only in the wet etching solution. However, according to the resist underlayer film-forming composition of the present invention, it is possible to provide a resist underlayer film capable of being subjected to such wet processing (etching (removal) with a wet etching solution).

The wet etching solution preferably contains, for example, an organic solvent, and may contain an acidic compound or a basic compound.

Examples of the organic solvent include dimethyl sulfoxide, dimethylformamide, dimethylacetamide, N-methylpyrrolidone, N-ethylpyrrolidone, ethylene glycol, propylene glycol, and diethylene glycol dimethyl ether.

Examples of the acidic compound include an inorganic acid and an organic acid, examples of the inorganic acid include hydrochloric acid, sulfuric acid, nitric acid, and phosphoric acid, and examples of the organic acid include p-toluenesulfonic acid, trifluoromethanesulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, acetic acid, propionic acid, trifluoroacetic acid, citric acid, benzoic acid, hydroxybenzoic acid, and naphthalenecarboxylic acid.

In addition, examples of the basic compound include an inorganic base and an organic base, and examples of the inorganic base include an alkali metal hydroxide such as sodium hydroxide or potassium hydroxide, a quaternary ammonium hydroxide such as tetramethylammonium hydroxide, tetraethylammonium hydroxide, or choline, and an amine such as ethanolamine, propylamine, diethylaminoethanol, or ethylenediamine.

Furthermore, the wet etching solution can use only one kind of organic solvent, or can use a combination of two or more kinds of organic solvents.

In addition, as the acidic compound or basic compound, only one kind of acidic compound or basic compound can be used, or two or more kinds of acidic compounds or basic compounds can be used in combination.

A blending amount of the acidic compound or the basic compound is 0.01 to 20 mass%, preferably 0.1 to 5 mass%, and particularly preferably 0.2 to 1 mass%, with respect to the wet etching solution. In addition, the wet etching solution is preferably an organic solvent containing a basic compound, and particularly preferably a mixed solution containing dimethyl sulfoxide and tetramethylammonium hydroxide.

Note that, in recent years, a fan-out wafer level package (FOWLP) process has started to be applied in the three-dimensional mounting field of semiconductor manufacturing processes, and a resist underlayer film can be applied in a redistribution layer (RDL) process for forming a copper wiring.

Typical RDL processes are described below, but are not limited thereto. First, a photosensitive insulating film is formed on a semiconductor chip, and then patterning is performed by light irradiation (exposure) and development to open a semiconductor chip electrode portion. Subsequently, a copper seed layer for forming a copper wiring to be a wiring member by a plating process is formed by sputtering. Further, after a resist underlayer film and a photoresist layer are sequentially formed, light irradiation and development are performed to form a pattern on a resist. An unnecessary resist underlayer film is removed by dry etching, and electrolytic copper plating is performed on the copper seed layer between the exposed resist patterns to form a copper wiring to be a first wiring layer. Further, the unnecessary resist, the resist underlayer film, and the copper seed layer are removed by dry etching or wet etching or both. Further, after the formed copper wiring layer is again covered with an insulating film, a copper seed layer, a resist underlayer film, and a resist are formed in this order, and resist patterning, resist underlayer film removal, and copper plating are performed to form a second copper wiring layer. This process is repeated to form a target copper wiring, and then a bump for extracting an electrode is formed.

Since the resist underlayer film-forming composition according to the present invention can remove the resist underlayer film by wet etching, it can be particularly preferably used as a resist underlayer film in such an RDL process from the viewpoint of simplifying the process step and reducing damage to the processed substrate.

### Examples

Hereinafter, the contents and effects of the present invention will be described in more detail by way of examples, but the present invention is not limited thereto.

A device and the like used for the measurement of weight-average molecular weights of polymers obtained in the following Synthesis Examples are shown.

Device: HLC-8420GPC manufactured by Tosoh Corporation
GPC column: Shodex [registered trademark] Asahipak [registered trademark] (manufactured by Showa Denko K.K.)
Column temperature: 40°C
Flow rate: 0.35 mL/min
Eluent: tetrahydrofuran (THF)
Standard sample: polystyrene (manufactured by Tosoh Corporation)

### <Synthesis Example 1>

A reaction flask was charged with 4.00g of curcumin, 1.73g of glycidol, 0.18 g of tetrabutylphosphonium bromide, and 24.00 g of propylene glycol monomethyl ether, and the mixture was heated and stirred at an internal temperature of 60°C for 24 hours under a nitrogen atmosphere. The obtained reaction product corresponded to Formula (1-1), and the weight-average molecular weight Mw measured in terms of polystyrene by GPC was 556.

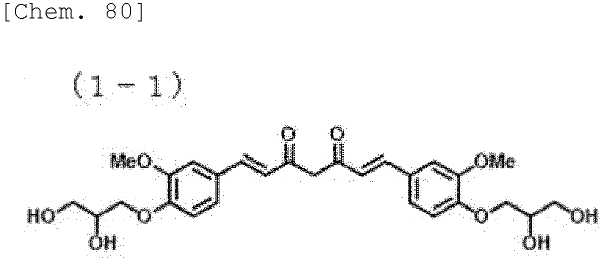

### <Synthesis Example 2>

A reaction flask was charged with 3.00 g of bisdemethoxycurcumin, 1.56 g of glycidol, 0.16 g of tetrabutylphosphonium bromide, and 18.00 g of propylene glycol monomethyl ether, and the mixture was heated and stirred at an internal temperature of 60°C for 24 hours under a nitrogen atmosphere. The obtained reaction product corresponded to Formula (1-2), and the weight-average molecular weight Mw measured in terms of polystyrene by GPC was 457.

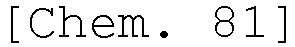

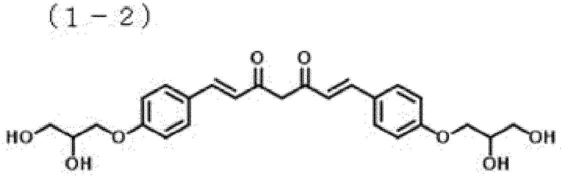

### <Synthesis Example 3>

A reaction flask was charged with 2.06 g of curcumin, 1.50 g of terephthalic acid diglycidyl ester (product name: EX-711, manufactured by Nagase ChemteX Corporation), 0.09 g of tetrabutylphosphonium bromide, and 14.60 g of propylene glycol monomethyl ether, and the mixture was heated and stirred at an internal temperature of 60°C for 24 hours under a nitrogen atmosphere. The obtained reaction product corresponded to Formula (1-3), and the weight-average molecular weight Mw measured in terms of polystyrene by GPC was 1,578.

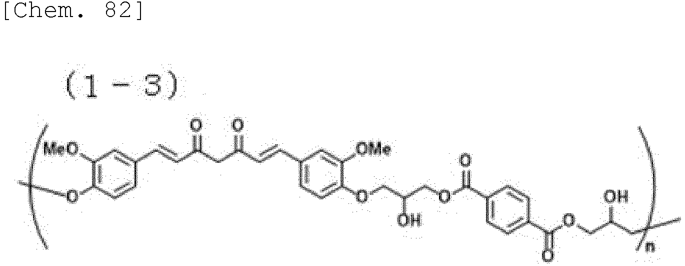

### <Synthesis Example 4>

A reaction flask was charged with 2.73 g of curcumin, 1.50 g of cyclohexanedimethanol diglycidyl ether (product name: EX-216L, manufactured by Nagase ChemteX Corporation), 0.12 g of tetrabutylphosphonium bromide, and 19.39 g of propylene glycol monomethyl ether, and the mixture was heated and stirred at an internal temperature of 105°C for 24 hours under a nitrogen atmosphere. The obtained reaction product corresponded to Formula (1-4), and the weight-average molecular weight Mw measured in terms of polystyrene by GPC was 4,581.

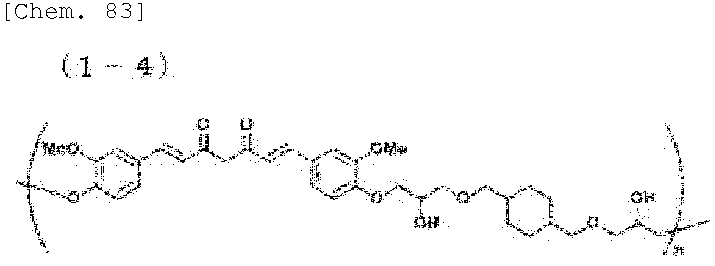

### <Synthesis Example 5>

Into a reaction flask, 15.00 g of a phenol novolak type epoxy resin (product name: DEN, manufactured by The Dow Chemical Company, epoxy functionality: 5.55 eq./kg), 10.17 g of 4-hydroxybenzaldehyde, 1.41 g of tetrabutylphosphonium bromide, and 39.87 g of propylene glycol monomethyl ether were added, then heated, and refluxed for 24 hours under a nitrogen atmosphere. Subsequently, a solution obtained by dissolving 5.50 g of malononitrile in 34.99 g of propylene glycol monomethyl ether was added to the system, and further heated and refluxed for 4 hours. The obtained reaction product corresponded to Formula (1-5), and the weight-average molecular weight Mw thereof measured in terms of polystyrene by GPC was 2,200.

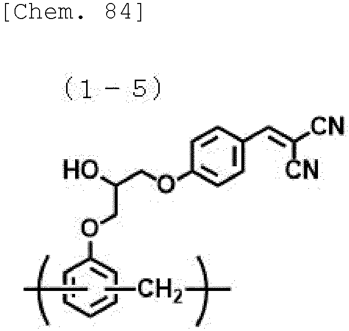

### <Synthesis Example 6>

A reaction flask was charged with 5.00 g of a triazinetrione-type epoxy compound (product name: TEPIC, manufactured by Nissan Chemical Corporation, and epoxy functionality: 10.02 eq/kg), 8.43 g of 1-thioglycerol, 0.64 g of tetrabutylphosphonium bromide, and 56.28 g of propylene glycol monomethyl ether, and the mixture was heated and stirred at an internal temperature of 105°C for 24 hours under a nitrogen atmosphere. The obtained reaction product corresponded to Formula (1-6), and the weight-average molecular weight Mw measured in terms of polystyrene by GPC was 518.

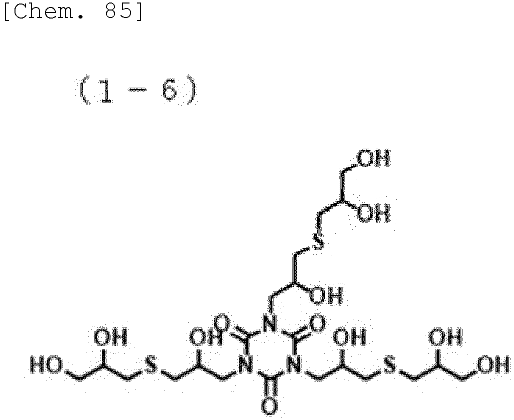

### <Example 1>

To 2.699 g of a solution (solid content: 14.34 mass%) of the reaction product corresponding to Formula (1-1) were added 0.077 g of tetramethoxymethylglycoluril (trade name: POWDER LINK [registered trademark] 1174, manufactured by Nihon Cytec Industries Inc.) as a crosslinking agent, 0.012 g of pyridinium-p-toluenesulfonate as a crosslinking catalyst, 0.004 g of MEGAFACE R-30N (manufactured by DIC Corporation, trade name), 4.456 g of propylene glycol monomethyl ether, and 0.752 g of propylene glycol monomethyl ether acetate to adjust a resist underlayer film-forming composition solution.

### <Example 2>

To 5.274 g of a solution (solid content: 17.0 mass%) of the reaction product corresponding to Formula (1-3) were added 0.269 g of tetramethoxymethylglycoluril (trade name: POWDER LINK [registered trademark] 1174, manufactured by Nihon Cytec Industries Inc.) as a crosslinking agent, 0.027 g of pyridinium-p-toluenesulfonate as a crosslinking catalyst, 0.009 g of MEGAFACE R-30N (manufactured by DIC Corporation, trade name), 12.542 g of propylene glycol monomethyl ether, and 1.880 g of propylene glycol monomethyl ether acetate to adjust a resist underlayer film-forming composition solution.

### <Example 3>

To 4.255 g of a solution of the reaction product corresponding to Formula (1-4) (solid content: 16.5 mass%) were added 0.175 g of tetramethoxymethylglycoluril (trade name: POWDER LINK [registered trademark] 1174, manufactured by Nihon Cytec Industries Inc.) as a crosslinking agent, 0.018 g of pyridinium-p-toluenesulfonate as a crosslinking catalyst, 0.007 g of MEGAFACE R-30N (manufactured by DIC Corporation, trade name), 3.495 g of propylene glycol monomethyl ether, and 7.050 g of cyclohexanone to adjust a resist underlayer film-forming composition solution.

### <Comparative Example 1>

To 1.645 g of a solution of a reaction product corresponding to Formula (1-5) (solid content: 28.6 mass%) were added 0.118 g of tetramethoxymethylglycoluril (trade name: POWDER LINK [registered trademark] 1174, manufactured by Nihon Cytec Industries Inc.) as a crosslinking agent, 0.012 g of pyridinium-p-toluenesulfonate as a crosslinking catalyst, 7.521 g of propylene glycol monomethyl ether, and 0.708 g of propylene glycol monomethyl ether acetate to adjust a resist underlayer film-forming composition solution.

### <Comparative Example 2>

To 2.539 g of a solution (solid content: 17.0 mass%) of the reaction product corresponding to Formula (1-6) were added 0.108 g of tetramethoxymethylglycoluril (trade name: POWDER LINK [registered trademark] 1174, manufactured by Nihon Cytec Industries Inc.) as a crosslinking agent, 0.013 g of pyridinium-p-toluenesulfonate as a crosslinking catalyst, 0.043 g of curcumin, 0.004 g of MEGAFACE R-30N (manufactured by DIC Corporation, trade name), 6.353 g of propylene glycol monomethyl ether, and 0.940 g of propylene glycol monomethyl ether acetate; however, curcumin did not dissolve, and a resist underlayer film-forming composition solution could not be adjusted.

### <Comparative Example 3>

To 2.539 g of a solution (solid content: 17.0 mass%) of the reaction product corresponding to Formula (1-6) were added 0.108 g of tetramethoxymethylglycoluril (trade name: POWDER LINK [registered trademark] 1174, manufactured by Nihon Cytec Industries Inc.) as a crosslinking agent, 0.013 g of pyridinium-p-toluenesulfonate as a crosslinking catalyst, 0.043 g of demethoxycurcumin, 0.004 g of MEGAFACE R-30N (manufactured by DIC Corporation, trade name), 6.353 g of propylene glycol monomethyl ether, and 0.940 g of propylene glycol monomethyl ether acetate to adjust a resist underlayer film-forming composition solution.

### <Evaluation of Optical Constant>

For an evaluation of the optical constant, the resist underlayer film-forming composition for lithography prepared in each of Examples 1 to 3, and Comparative Examples 1 and 3 was applied onto a silicon wafer with a spin coater so as to have a film thickness of about 50 nm, and baked on a hot plate at 200°C for 90 seconds. An n-value (refractive index) and a k-value (attenuation coefficient) of the obtained resist underlayer film were measured at a wavelength of 365 nm (i-ray wavelength) using a spectroscopic ellipsometer (VUV-VASE, manufactured by J.A.Woolam). The results are shown in Table 1.

**[Table 1]**

| | n/k (365 nm) |
|---|---|
| Example 1 | 1.68/0.31 |
| Example 2 | 1.63/0.21 |
| Example 3 | 1.61/0.14 |
| Comparative Example 1 | 1.81/0.34 |
| Comparative Example 3 | 1.64/0.04 |

In Examples 1 to 3, an appropriate n value and an appropriate k value are obtained at a wavelength of 365 nm. From the above results, the coating film obtained from the resist underlayer film-forming composition obtained in each of Examples 1 to 3 has an anti-reflective function capable of suppressing reflection (standing wave), which may cause an unfavorable resist pattern, from a base substrate in a lithography process in which a radiation such as i-ray is used. Therefore, the coating film is useful as a resist underlayer film.

### <Test of Removability in Resist Solvent>

For an evaluation of removability in a resist solvent (organic solvent), the resist underlayer film-forming composition prepared in each of Examples 1 to 3 and Comparative Example 1 was applied onto a copper substrate having a thickness of 50 nm, and heated at 200°C for 90 seconds to form a resist underlayer film having a thickness of 150 nm. Next, the copper substrate coated with the resist underlayer film composition was immersed in propylene glycol monomethyl ether acetate (PGMEA), which is a general resist solvent, at room temperature for 1 minute, and the removability of the coating film after immersion was visually observed. The results are shown in Table 2. Note that, in a case where the coating film was removed, it was determined that the coating film did not have resistance to a resist solvent (organic solvent), and in a case where the coating film was not removed, it was determined that the coating film had resistance.

**[Table 2]**

| | Removability of coatability in resist solvent (PGMEA) |
|---|---|
| Example 1 | No peeling |
| Example 2 | No peeling |
| Example 3 | No peeling |
| Comparative Example 1 | No peeling |

From the above results, in the resist underlayer film composition of each of Examples 1 to 3 and Comparative Example 1, since the coating film on the copper substrate was not removed (peeled) in PGMEA, it can be said that the resist underlayer film-forming composition has excellent chemical resistance to the resist solvent. That is, since the coating film obtained using the resist underlayer film composition of each of Example 1 and Comparative Examples 1 to 3 can suppress an unfavorable peeling phenomenon due to the resist solvent, the coating film is useful as a resist underlayer film.

### <Test of Removability in Resist Developer>

For an evaluation of removability in a resist developer (alkaline aqueous solution), the resist underlayer film-forming composition solution prepared in each of Examples 1 to 3 and Comparative Example 1 was applied onto a copper substrate having a thickness of 50 nm, and heated at 200°C for 90 seconds to form a resist underlayer film having a thickness of 150 nm. Next, the copper substrate coated with the resist underlayer film composition was immersed in 2.38 mass% of a tetramethylammonium hydroxide (TMAH) aqueous solution (product name: NMD-3, manufactured by TOKYO OHKA KOGYO CO., LTD.), which is an alkaline aqueous solution, at room temperature for 1 minute, and the removability of the coating film after immersion was visually observed. The results are shown in Table 3. Note that, in a case where the coating film was removed, it was determined that the coating film did not have resistance to a resist developer (alkaline aqueous solution), and in a case where the coating film was not removed, it was determined that the coating film had resistance.

**[Table 3]**

| | Removability of coating film in resist developer (2.38 wt% of TMAH aqueous solution) |
|---|---|
| Example 1 | No peeling |
| Example 2 | No peeling |
| Example 3 | No peeling |
| Comparative Example 1 | No peeling |

From the above results, in the resist underlayer film composition of each of Examples 1 to 3 and Comparative Example 1, since the coating film on the copper substrate was not removed (peeled) in the TMAH aqueous solution, it can be said that the resist underlayer film composition has excellent chemical resistance to the resist developer (alkaline aqueous solution). That is, the coating film obtained using the resist underlayer film composition of each of Examples 1 to 3 is useful as a resist underlayer film that requires a development process with an alkaline aqueous solution because it does not cause the unfavorable peeling phenomenon due to the resist developer.

### <Test of Solubility in Wet Etching Chemical Liquid>

For an evaluation of removability in a wet etching chemical liquid (basic organic solvent), the resist underlayer film-forming composition solution prepared in each of Examples 1 to 3 and Comparative Example 1 was applied onto a copper substrate having a thickness of 50 nm, and heated at 200°C for 90 seconds to form a resist underlayer film having a thickness of 150 nm. Next, the copper substrate coated with the resist underlayer film composition was immersed in a dimethyl sulfoxide solution of 0.5 mass% of tetramethylammonium hydroxide (TMAH), which is a basic organic solvent, at 70°C for 10 minutes, and the removability of the coating film after immersion was visually observed. The results are shown in Table 4. Note that, when the coating film was removed, it was determined that the coating film had excellent removability (peelability) in a basic organic solvent, and when the coating film was not removed, it was determined that the coating film did not have excellent removability (peelability) .

**[Table 4]**

| | Removability of coating film in wet etching chemical liquid (dimethyl sulfoxide solution of 0.5 wt% of TMAH) |
|---|---|
| Example 1 | Whole peeling |
| Example 2 | Whole peeling |
| Example 3 | Whole peeling |
| Comparative Example 1 | No peeling |

From the above results, in the case of the resist underlayer film composition in each of Examples 1 to 3, the coating film on the copper substrate had sufficient removability in a wet etching chemical liquid (basic organic solvent) as compared with the resist underlayer film composition in Comparative Example 1. That is, since the coating film obtained using the resist underlayer film composition in each of Examples 1 to 3 can exhibit excellent removability (peelability) in a wet etching chemical liquid, the coating film is useful in a semiconductor manufacturing process of removing the resist underlayer film using a wet etching chemical liquid.

### Industrial Applicability

According to the present invention, it is possible to provide a resist underlayer film that exhibits excellent removability and preferably solubility only in a wet etching chemical liquid while mainly exhibiting excellent resistance to a resist solvent, which is an organic solvent, or a resist developer, which is an alkaline aqueous solution.

## Claims

1. A resist underlayer film-forming composition comprising: at least any one of a compound having a partial structure represented by Formula (1) or a polymer having a partial structure represented by Formula (1); and a solvent, 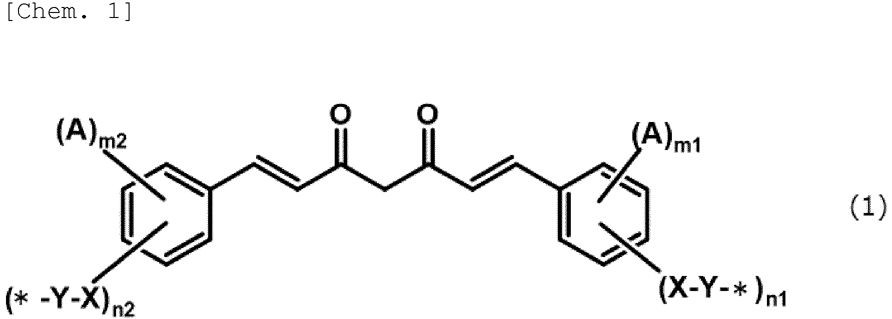 wherein each -X- independently represents -O-, -S-, - NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.

2. The resist underlayer film-forming composition according to claim 1, wherein
the compound having a partial structure represented by Formula (1) or the polymer having the partial structure represented by Formula (1) is
a reaction product of a compound represented by any one of Formulae (A-1) to (A-4) and a mono-, bi-, or polyfunctional epoxy compound,
a reaction product of a compound represented by any one of Formulae (A-1) to (A-3) and a mono-, bi-, or polyfunctional carboxylic acid,
a reaction product of a compound represented by Formula (A-4) and a monovalent, divalent, or multivalent alcohol, or a phenol or polyphenol having one or two or more phenolic hydroxyl groups, or
a reaction product of a compound represented by Formula (A-4) and a monovalent, divalent, or multivalent thiol, or a thiophenol or polythiophenol having one or two or more thiophenolic mercapto groups, 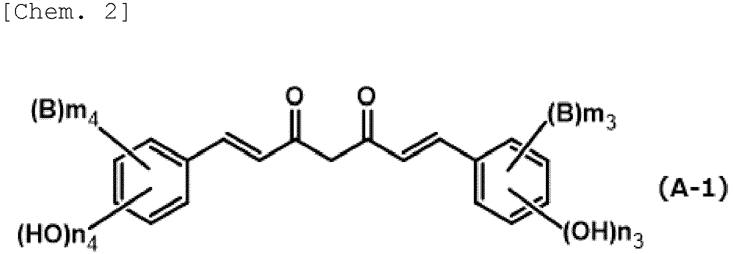 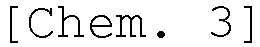 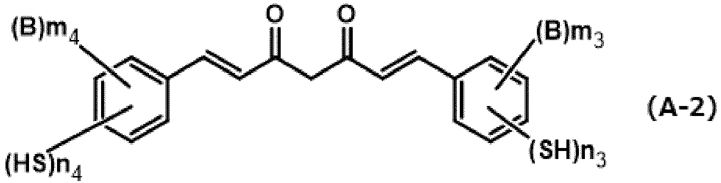 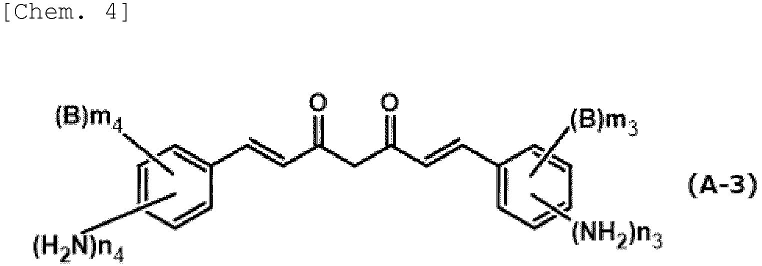 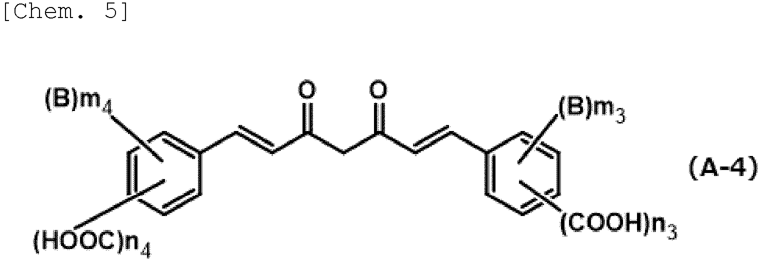
wherein each B independently represents an alkyl group, a halogen atom, or an alkoxy group; n₃ satisfies 1 ≤ n₃ ≤ 5, m₃ satisfies 0 ≤ m₃ ≤ 4, and n₃ and m₃ satisfy n₃ + m₃ ≤ 5; and n₄ satisfies 1 ≤ n₄ ≤ 5, m₄ satisfies 0 ≤ m₄ ≤ 4, and n₄ and m₄ satisfy n₄ + m₄ ≤ 5.

3. The resist underlayer film-forming composition according to claim 1, wherein
the compound having a partial structure represented by Formula (1) is a compound represented by Formula (2-1), a compound represented by Formula (2-2), a compound represented by Formula (2-3), or a compound represented by Formula (2-4), and
the polymer having the partial structure represented by Formula (1) is a polymer having a repeating unit represented by Formula (3-1), a polymer having a repeating unit represented by Formula (3-2), a polymer having a repeating unit represented by Formula (3-3), or a polymer having a repeating unit represented by Formula (3-4), 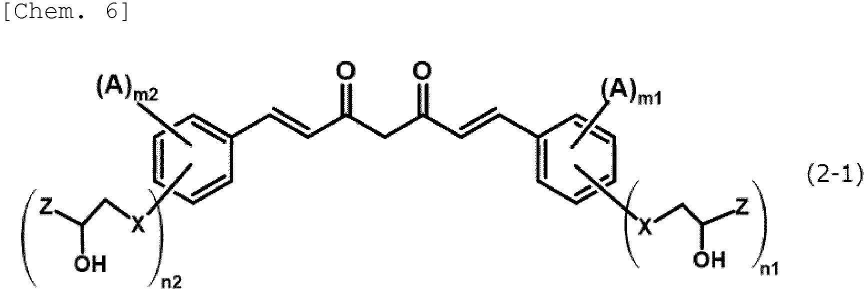
wherein each -Z independently represents -L₁, -CH₂OH, - CH₂OL₁, or -CH₂OC(=O)L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 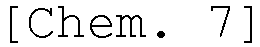 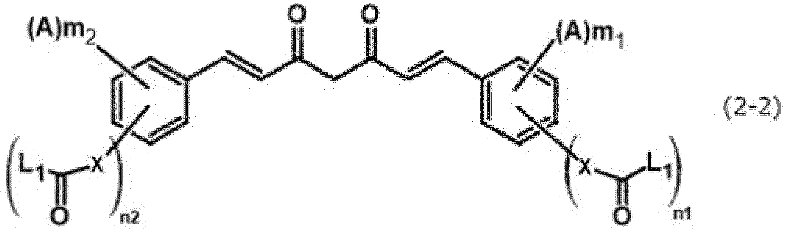
wherein each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 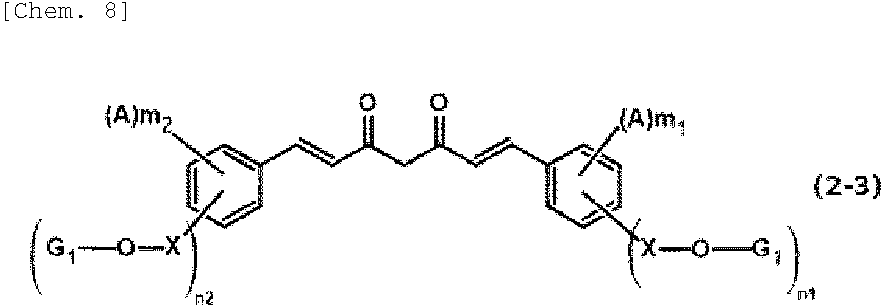
wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 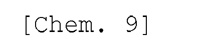 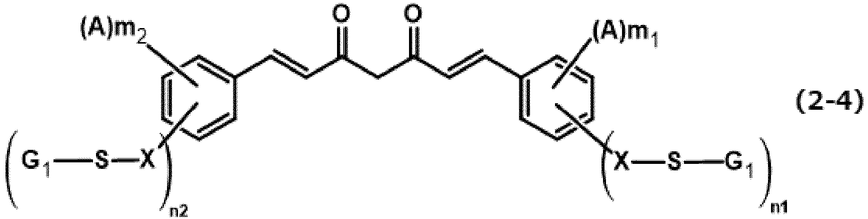
wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 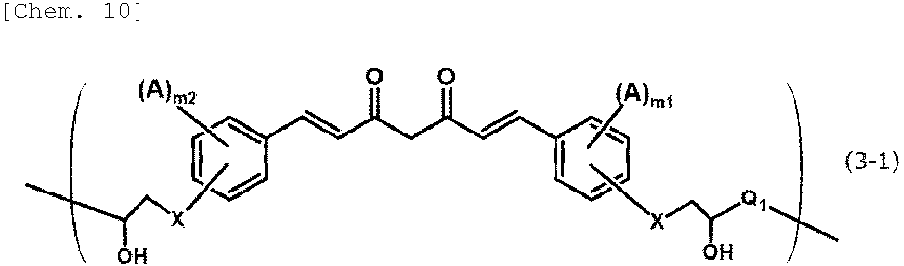
wherein -Q₁- represents -T₁-, -CH₂O-T₁-O-CH₂-, -CH₂OCH₂-T₁-CH₂OCH₂-, or -CH₂OC(=O)-T₁-C(=O)OCH₂-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 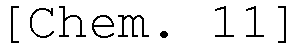 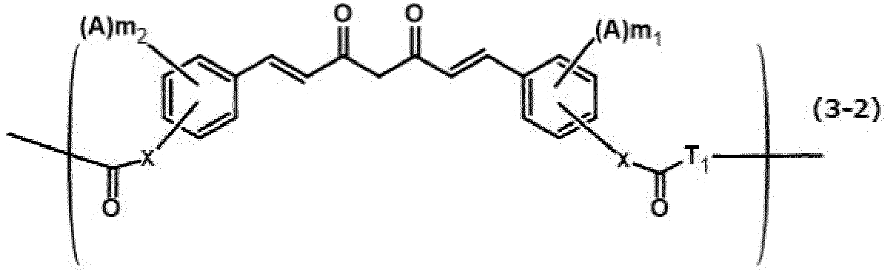
wherein T₁ represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 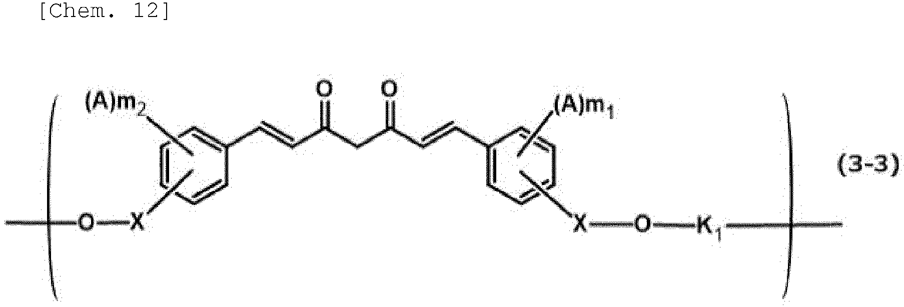
wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 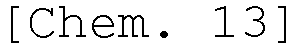 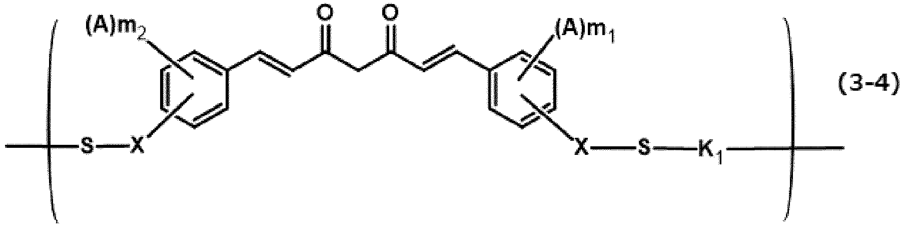
wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4.

4. The resist underlayer film-forming composition according to claim 1, further comprising at least one selected from the group consisting of a crosslinking agent, an acid, and an acid generator.

5. The resist underlayer film-forming composition according to claim 1, wherein the resist underlayer film-forming composition is applied onto a substrate containing copper on a surface of the substrate.

6. A resist underlayer film obtained by removing a solvent from a coating film containing the resist underlayer film-forming composition according to any one of claims 1 to 4.

7. A resist underlayer film comprising the resist underlayer film-forming composition according to any one of claims 1 to 4, the resist underlayer film-forming composition being baked, dried, or concentrated.

8. The resist underlayer film according to claim 6, wherein the resist underlayer film is formed on a substrate containing copper on a surface of the substrate.

9. A substrate comprising: a copper seed layer; and the resist underlayer film according to claim 6 formed on the copper seed layer, wherein the copper seed layer and the resist underlayer film are formed on a surface of the substrate.

10. A method for manufacturing a substrate including a patterned resist film, the method comprising:
a step of applying the resist underlayer film-forming composition according to any one of claims 1 to 4 onto a surface of a substrate, in which the surface contains copper, and baking the resist underlayer film-forming composition to form a resist underlayer film;
a step of applying a resist onto the resist underlayer film and baking the resist to form a resist film;
a step of exposing a semiconductor substrate coated with the resist underlayer film and the resist; and
a step of developing the resist film after the exposing, and performing patterning.

11. A method for manufacturing a semiconductor device, the method comprising:
a step of forming a resist underlayer film containing the resist underlayer film-forming composition according to any one of claims 1 to 4 on a substrate containing copper on a surface of the substrate;
a step of forming a resist film on the resist underlayer film;
a step of irradiating the resist film with light or an electron beam and developing the resist film to form a resist pattern, and subsequently removing the resist underlayer film exposed between the resist patterns;
a step of performing copper plating between the formed resist patterns; and
a step of removing the resist patterns and the resist underlayer film existing under the resist patterns.

12. The method for manufacturing a semiconductor device according to claim 11, wherein at least one of the steps of removing the resist underlayer film is performed by wet processing.

13. A compound having a partial structure represented by Formula (1), 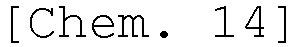 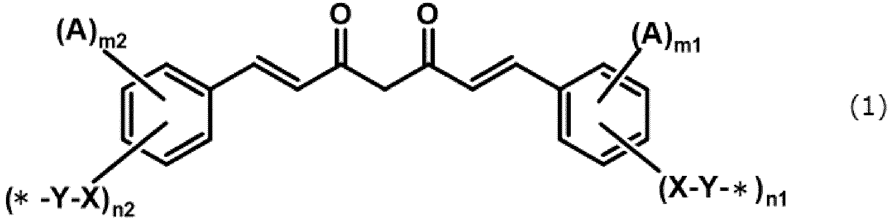 wherein each -X- independently represents -O-, -S-, - NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.

14. The compound according to claim 13, wherein the compound having a partial structure represented by Formula (1) is a compound represented by Formula (2-1), a compound represented by Formula (2-2), a compound represented by Formula (2-3), or a compound represented by Formula (2-4), 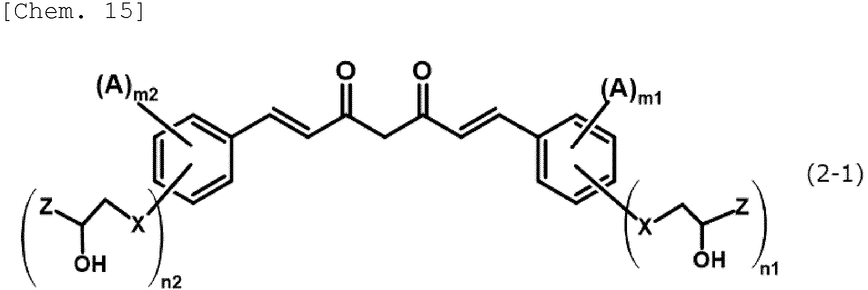 wherein each -Z independently represents -L₁, -CH₂OH, - CH₂OL₁, or -CH₂OC(=O)L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 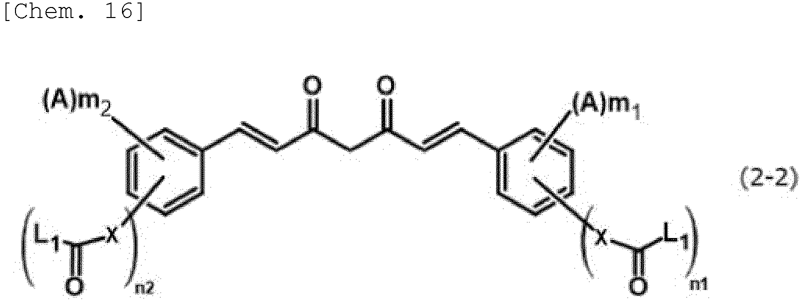 wherein each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 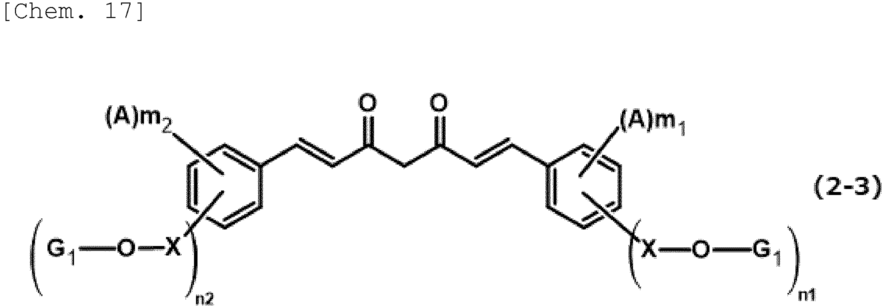 wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1), 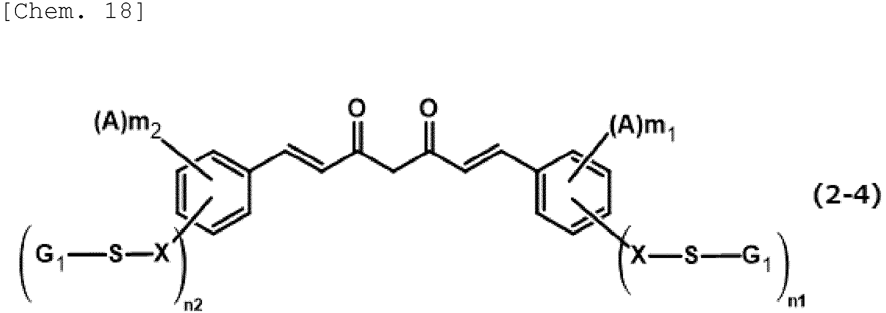 wherein each -G₁ independently represents -CH₂L₁ or - C₆H₄L₁, where each L₁ independently represents a monovalent acyclic group or a monovalent group having a cyclic structure; -X- and A are identical to -X- and A in Formula (1); and n₁, m₁, n₂, and m₂ are also identical to n₁, m₁, n₂, and m₂ in Formula (1).

15. A polymer having a partial structure represented by Formula (1), 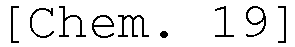 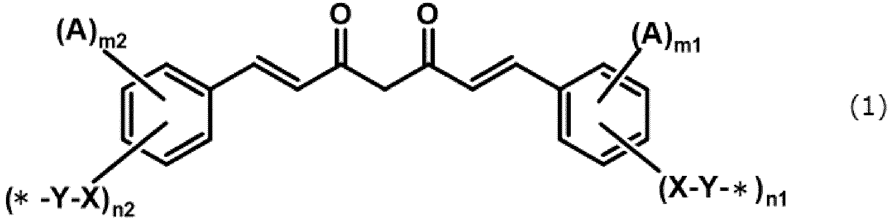 wherein each -X- independently represents -O-, -S-, **-** NH-, -C(=O)O-, or -C(=O)-; each -Y- independently represents -CH₂CH(OH)-, -C(=O)-, -O-, or -S-; A represents an alkyl group, a hydroxy group, a halogen atom, or an alkoxy group; n₁ satisfies 1 ≤ n₁ ≤ 5, m₁ satisfies 0 ≤ m₁ ≤ 4, and n₁ and m₁ satisfy n₁ + m₁ ≤ 5; n₂ satisfies 1 ≤ n₂ ≤ 5, m₂ satisfies 0 ≤ m₂ ≤ 4, and n₂ and m₂ satisfy n₂ + m₂ ≤ 5; and * represents a bond.

16. The polymer according to claim 15, wherein the polymer having the partial structure represented by Formula (1) is a polymer having a repeating unit represented by Formula (3-1), a polymer having a repeating unit represented by Formula (3-2), a polymer having a repeating unit represented by Formula (3-3), or a polymer having a repeating unit represented by Formula (3-4), 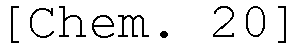 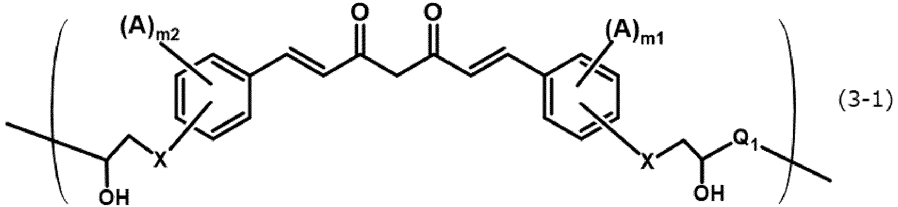 wherein -Q₁- represents -T₁-, -CH₂O-T₁-O-CH₂-, -CH₂OCH₂-T₁-CH₂OCH₂-, or -CH₂OC(=O)-T₁-C(=O)OCH₂-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 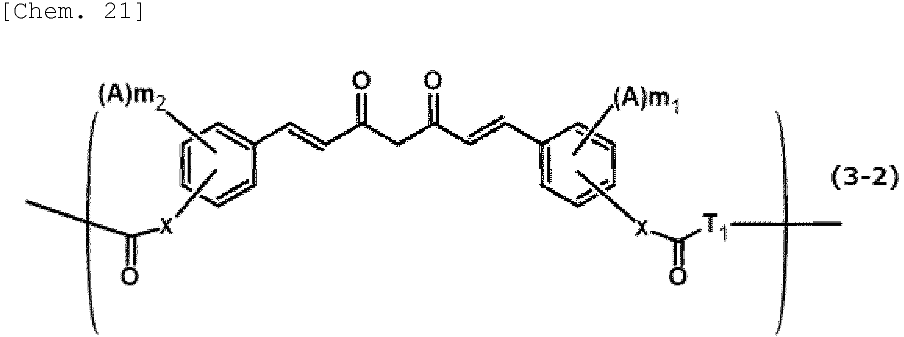 wherein T₁ represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 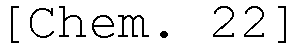 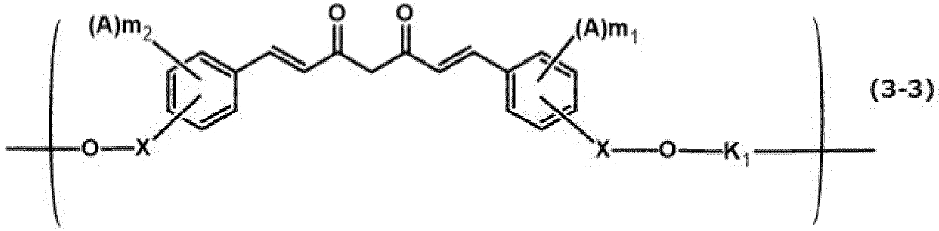 wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4, 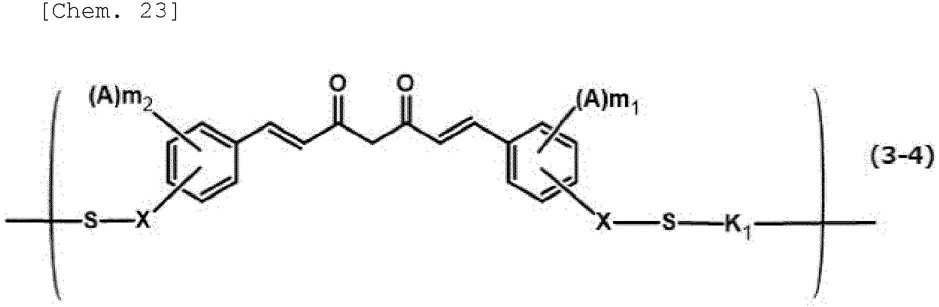 wherein -K₁- represents -CH₂-T₁-CH₂- or -C₆H₄-T₁-C₆H₄-, where each T₁ independently represents a divalent acyclic group or a divalent group having a cyclic structure; -X- and A are identical to -X- and A in Formula (1); and m₁ satisfies 0 ≤ m₁ ≤ 4, and m₂ satisfies 0 ≤ m₂ ≤ 4.
